(19) 

Europäisches
Patentamt
European
Patent Office
Office européen
des brevets

(11) **EP 4 693 906 A1**

(12) **EUROPEAN PATENT APPLICATION**
published in accordance with Art. 153(4) EPC

(43) Date of publication:
**11.02.2026 Bulletin 2026/07**

(21) Application number: **23935129.9**

(22) Date of filing: **11.12.2023**

(51) International Patent Classification (IPC):
***H03M 13/11*** *(2006.01)*

(52) Cooperative Patent Classification (CPC):
**H03M 13/11**

(86) International application number:
**PCT/CN2023/137968**

(87) International publication number:
**WO 2024/221963 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.04.2023 CN 202310481751**

(71) Applicant: **ZTE CORPORATION**
**Shenzhen, Guangdong 518057 (CN)**

(72) Inventors:
• **YANG, Xiaoling**
**Shenzhen, Guangdong 518057 (CN)**

• **XU, Jin**
**Shenzhen, Guangdong 518057 (CN)**
• **LIANG, Chulong**
**Shenzhen, Guangdong 518057 (CN)**
• **LI, Liguang**
**Shenzhen, Guangdong 518057 (CN)**
• **YU, Guanghui**
**Shenzhen, Guangdong 518057 (CN)**
• **FU, Qiang**
**Shenzhen, Guangdong 518057 (CN)**
• **KANG, Jian**
**Shenzhen, Guangdong 518057 (CN)**

(74) Representative: **Brunazzi, Stefano**
**Jacobacci & Partners S.p.A.**
**Via Senato, 8**
**20121 Milano (IT)**

(54) **CODING METHOD AND DEVICE FOR NON-BINARY QUASI-CYCLIC LOW DENSITY PARITY CHECK (LDPC) CODE**

(57) Embodiments of the present invention provide a coding method and device for a non-binary quasi-cyclic low density parity check (LDPC) code. The method comprises: determining a base matrix of a non-binary quasi-cyclic LDPC code, wherein the base matrix comprises a first element for indicating an all-zero square matrix and a second element for indicating a cyclic shift value of a unit matrix; extending the base matrix according to a lifting factor to obtain an extended matrix; obtaining a parity check matrix of the non-binary quasi-cyclic LDPC code according to non-binary values of non-zero positions in the extended matrix; and performing non-binary quasi-cyclic LDPC code coding on an input information bit sequence on the basis of the parity check matrix to obtain a sequence of codewords to be sent.

Fig. 3

Determining a base matrix of a non-binary quasi-cyclic LDPC code, wherein the base matrix comprises a first element for indicating an all-zero square matrix and a second element for indicating a cyclic shift value of a unit matrix — S302

Extending the base matrix according to a lifting factor to obtain an extended matrix — S304

Obtaining a parity check matrix of the non-binary quasi-cyclic LDPC code according to non-binary values at non-zero positions in the extended matrix — S306

Performing non-binary quasi-cyclic LDPC coding on an input information bit sequence based on the parity check matrix to obtain a codeword sequence to be sent — S308

EP 4 693 906 A1

**Description**

**Cross-Reference to Related Application**

The present disclosure is based on and claims priority to Chinese patent application No.CN202310481751.9 filed on April 27, 2023, entitled "Coding Method and Device for Non-Binary Quasi-Cyclic Low Density Parity Check (LDPC) Code", the disclosure of which is incorporated herein by reference in its entirety.

**Technical Field**

Embodiments of the present disclosure relate to the field of communications, and in particular, to a coding method and device for a non-binary quasi-cyclic LDPC code.

**Background**

With the development of wireless digital communication and the emergence of various high-speed and burst services, communication systems have increasingly higher demands for error-correcting coding techniques. The LDPC code is a type of linear block code defined by a sparse parity check matrix or a bipartite graph, and is characterized by its performance close to the Shannon limit, linear-time encodability, low decoding complexity, parallel decodability, and superiority over Turbo codes at long code lengths. Thanks to its superior performance, a binary quasi-cyclic LDPC code is adopted as a coding scheme for data channel of 5G New Radio (NR) in the 5th Generation Mobile Communication (5G) standard set by the 3rd Generation Mobile Communication Partnership Project (3GPP).

All non-zero elements in the parity check matrix of the binary LDPC code are "1". If the non-zero elements of this parity check matrix are taken from a larger Galois field set, a linear block code over a larger symbol set is defined, and such code is referred to as a non-binary LDPC code. Research has shown that at medium and short code lengths, compared with a binary LDPC code of the same bit length, a non-binary LDPC code has the following advantages: more coding gain (1~1.3dB), lower error floors, stronger resistance to burst errors, and easier integration with higher-order modulation. Therefore, the non-binary LDPC code is expected to be applied to communication systems with strict latency requirements and high reliability requirements, such as scenarios that satisfy real-time, reliability, throughput, and massive connection demands in the next stage of standardization.

However, in some scenarios, the non-binary LDPC code faces many issues, including high storage space requirements and complex coding processes, which to some extent hinder its application in actual communication systems.

**Summary**

A coding method and device for a non-binary quasi-cyclic LDPC code are provided in the embodiments of the present disclosure, which may at least solve the problems of high storage space requirements and complex coding processes of a non-binary LDPC code in the related art.

According to an embodiment of the present disclosure, a coding method for a non-binary quasi-cyclic Low Density Parity Check (LDPC) code is provided. The coding method includes: determining a base matrix of a non-binary quasi-cyclic LDPC code, wherein the base matrix includes a first element indicating an all-zero square matrix and a second element indicating a cyclic shift value of a unit matrix; extending the base matrix according to a lifting factor to obtain an extended matrix; obtaining a parity check matrix of the non-binary quasi-cyclic LDPC code according to non-binary values at non-zero positions in the extended matrix; and performing non-binary quasi-cyclic LDPC coding on an input information bit sequence based on the parity check matrix to obtain a codeword sequence to be sent.

According to another embodiment of the present disclosure, a coding device for a non-binary quasi-cyclic Low Density Parity Check (LDPC) code is provided. The coding device includes: a determination module, configured to determine a base matrix of a non-binary quasi-cyclic LDPC code, wherein the base matrix includes a first element indicating an all-zero square matrix and a second element indicating a cyclic shift value of a unit matrix; an extension module, configured to extend the base matrix according to a lifting factor to obtain an extended matrix; an obtaining module, configured to obtain a parity check matrix of the non-binary quasi-cyclic LDPC code according to non-binary values at non-zero positions in the extended matrix; and a coding module, configured to perform non-binary quasi-cyclic LDPC coding on an input information bit sequence based on the parity check matrix to obtain a codeword sequence to be sent.

According to another embodiment of the present disclosure, a computer-readable storage medium is provided. The computer-readable storage medium stores a computer program, and the computer program, when executed by a processor, causes the processor to execute any one of the described methods.

According to another embodiment of the present disclosure, an electronic device is provided. The electronic device includes a memory, a processor, and a computer program stored in the memory and executable on the processor, wherein the processor, when executing the computer program, implements any one of the described methods.

**Brief Description of the Drawings**

Fig. 1 is a block diagram illustrating the hardware structure of a computer terminal for implementing a coding method for a non-binary quasi-cyclic LDPC code according to some embodiments of the present disclosure;

Fig. 2 is a network architecture diagram of a coding method for a non-binary quasi-cyclic LDPC code according to some embodiments of the present disclosure;

Fig. 3 is a flowchart of a coding method for a non-binary quasi-cyclic LDPC code according to some embodiments of the present disclosure;

Fig. 4 is a block diagram of a coding device for a non-binary quasi-cyclic LDPC code according to some embodiments of the present disclosure;

Fig. 5 is a schematic diagram of a diagonal structure according to a scenario-based embodiment of the present disclosure;

Fig. 6 is a schematic diagram of a double diagonal structure according to a scenario-based embodiment of the present disclosure;

Fig. 7 is a schematic diagram of an approximate double diagonal structure according to a scenario-based embodiment of the present disclosure;

Fig. 8 is a schematic diagram of a triangular matrix structure according to a scenario-based embodiment of the present disclosure;

Fig. 9 is a schematic diagram of a combined structure according to a scenario-based embodiment of the present disclosure;

Fig. 10 is a schematic diagram of a structure of a base matrix according to a scenario-based embodiment of the present disclosure;

Fig. 11 is a schematic diagram of an overall structure of a base matrix whose first sub-matrix square has a lower double main diagonal structure according to a scenario-based embodiment of the present disclosure;

Fig. 12 is a schematic diagram of an overall structure of a base matrix whose first sub-matrix square has an upper double main diagonal structure according to a scenario-based embodiment of the present disclosure;

Fig. 13 is a schematic diagram of an overall structure of a base matrix whose first sub-matrix square has a lower double anti-diagonal structure according to a scenario-based embodiment of the present disclosure;

Fig. 14 is a schematic diagram of an overall structure of a base matrix whose first sub-matrix square has an upper double anti-diagonal structure according to a scenario-based embodiment of the present disclosure;

Fig. 15 is a schematic diagram of an overall structure of a base matrix whose first sub-matrix square has an approximate lower double main diagonal structure according to a scenario-based embodiment of the present disclosure;

Fig. 16 is a schematic diagram of an overall structure of a base matrix whose first sub-matrix square has an approximate upper double main diagonal structure according to a scenario-based embodiment of the present disclosure;

Fig. 17 is a schematic diagram of an overall structure of a base matrix whose first sub-matrix square has an approximate lower double anti-diagonal structure according to a scenario-based embodiment of the present disclosure;

Fig. 18 is a schematic diagram of an overall structure of a base matrix whose first sub-matrix square has an approximate upper double anti-diagonal structure according to a scenario-based embodiment of the present disclosure;

Fig. 19 is a schematic diagram of an overall structure of a base matrix whose first sub-matrix square has a lower main triangular matrix structure according to a scenario-based embodiment of the present disclosure;

Fig. 20 is a schematic diagram of an overall structure of a base matrix whose first sub-matrix square has an upper main triangular matrix structure according to a scenario-based embodiment of the present disclosure;

Fig. 21 is a schematic diagram of an overall structure of a base matrix whose first sub-matrix square has an upper anti-triangular matrix structure according to a scenario-based embodiment of the present disclosure;

Fig. 22 is a schematic diagram of an overall structure of a base matrix whose first sub-matrix square has a lower anti-triangular matrix structure according to a scenario-based embodiment of the present disclosure;

Fig. 23 is a schematic diagram of an overall structure of a base matrix whose first sub-matrix square has a combined structure according to a scenario-based embodiment of the present disclosure;

Fig. 24 is an overall structural diagram of a base matrix according to a scenario-based embodiment of the present disclosure; and

Fig. 25 is an overall structural diagram of a base matrix according to a scenario-based embodiment of the present disclosure.

## Detailed Description of the Embodiments

Hereinafter, the embodiments of the present disclosure will be described in detail with reference to the accompanying drawings and embodiments.

It should be noted that terms such as "first" and "second" in the description and claims of the embodiments of the present disclosure and the drawings are used to distinguish similar objects, and are not necessarily used to describe a specific sequence or order.

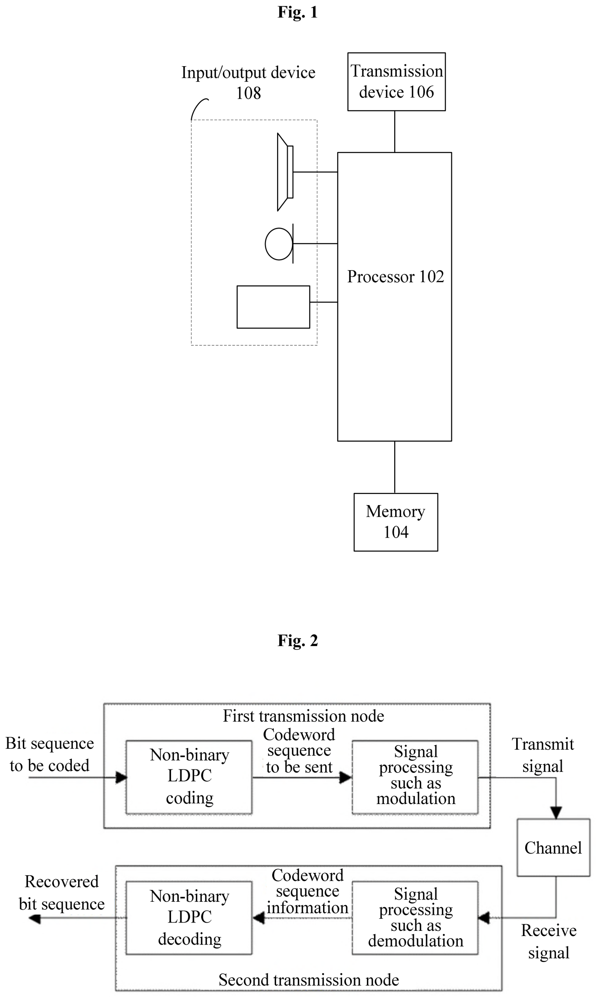

The method embodiments provided in the embodiments of the present disclosure may be executed in a computer terminal or a similar computing device. Taking the operation on a mobile terminal as an example, Fig. 1 is a block diagram illustrating the hardware structure of a computer terminal for implementing a coding method for a non-binary quasi-cyclic LDPC code according to some embodiments of the present disclosure. As shown in Fig. 1, the computer terminal may include one or more (only one is shown in Fig. 1) processors 102 (each of the one or more processors 102 may include, but is not limited to, a microprocessor (e.g., a Micro-Controller Unit (MCU)) or a processing apparatus such as a programmable logic device (e.g., Field Programmable Gate Array (FPGA)) and a memory 104 for storing data. The computer terminal may further include a transmission device 106 for a communication function and an input/output device 108. The structure shown in Fig. 1 is only illustrative, which does not limit the structure of the computer terminal. For example, the computer terminal may further include more or fewer components than shown in Fig. 1, or have a different configuration from that shown in Fig. 1.

The memory 104 may be used for storing a computer program, such as a software program and modules of application software, such as a computer program corresponding to the coding method for the non-binary quasi-cyclic LDPC code in the embodiments of the present disclosure. The one or more processors 102 run the computer program stored in the memory 104, so as to execute various function applications and data processing, i.e., to realize the described method. The memory 104 may include a high-speed random access memory, and may also include a non-volatile memory, such as one or more magnetic storage devices, flash memory, or other non-volatile solid-state memory. In some embodiments, the memory 104 may further include a memory remotely located with respect to the one or more processors 102, which may be connected to the computer terminal over a network. Examples of such networks include, but are not limited to, the Internet, intranets, local area networks, mobile communication networks, and combinations thereof.

The transmission device 106 is used to receive or transmit data via a network. Examples of the above-described network may include a wireless network provided by a communication provider of the mobile terminal. In an embodiment, the transmission device 106 may include a Network Interface Controller (NIC) that may interface with other network devices via a base station to communicate with the Internet. In an embodiment, the transmission device 106 may be a Radio Frequency (RF) module for communicating wirelessly with the Internet.

First, technical terms involved in the embodiments of the present disclosure are explained.

Quasi-cyclic LDPC code:

A parity check matrix H of the quasi-cyclic LDPC code is set as a $(M_b \times Z) \times (N_b \times Z)$ matrix, and is as shown in the following formula:

$$H = \begin{bmatrix} P^{h^b_{0,0}} & P^{h^b_{0,1}} & P^{h^b_{0,2}} & \cdots & P^{h^b_{0,N_b-1}} \\ P^{h^b_{1,0}} & P^{h^b_{1,1}} & P^{h^b_{1,2}} & \cdots & P^{h^b_{1,N_b-1}} \\ \vdots & \vdots & \vdots & \ddots & \vdots \\ P^{h^b_{M_b-1,0}} & P^{h^b_{M_b-1,1}} & P^{h^b_{M_b-1,2}} & \cdots & P^{h^b_{M_b-1,N_b-1}} \end{bmatrix} = P^{H_b}.$$

The parity check matrix $H$ consists of $M_b \times N_b$ block matrices, each of which is a $Z \times Z$ basic permutation matrix P raised to different powers or a $Z \times Z$ zero matrix. When the basic permutation matrix is a unit matrix, different powers of the basic permutation matrix correspond to cyclic shift matrices (in the embodiments of the present disclosure, the cyclic shift is assumed to be a right shift) of the unit matrix. The block matrices can be uniquely represented by a power $h^b_{i,j}$, typically as follows: when $h^b_{i,j} = -1$, the block matrix is an all-zero matrix; when $h^b_{i,j}$ is a non-negative integer, the block matrix is the $h^b_{i,j}$-th power of the basic permutation matrix P. The $Z \times Z$ basic permutation matrix P is a matrix obtained by cyclically right-shifting the unit matrix by one column, as shown below.

$$P = \begin{bmatrix} 0 & 1 & 0 & \cdots & 0 \\ 0 & 0 & 1 & \cdots & 0 \\ \cdots & \cdots & \cdots & \cdots & \cdots \\ 0 & 0 & 0 & \cdots & 1 \\ 1 & 0 & 0 & \cdots & 0 \end{bmatrix}$$

In this way, the powers $h^b_{i,j}$ of the respective block matrices together form a power matrix $H_b$ having a dimension of $M_b \times N_b$, where $i$ and $j$ respectively correspond to a row index and a column index of $H_b$. It can be seen from the typical form that elements in the power matrix $H_b$ may be divided into two types: elements indicating an all-zero square matrix and elements indicating a cyclic shift value of a unit matrix. Here, we define that $H_b$ is a base matrix of $H$, $H$ is an extended matrix of $H_b$, and $Z$ is a lifting factor, then $Z = \dfrac{\text{code length}}{\text{column number } N_b \text{ of } H_b}$ in the actual coding process.

Thus, the quasi-cyclic LDPC code can be uniquely generated from the base matrix $H_b$, the lifting factor $Z$, and the chosen basic permutation matrix $P$. In the embodiments of the present disclosure, the basic permutation matrix $P$ is a square matrix obtained by cyclically shifting the unit matrix by 1 column. Each element of the base matrix $H_b$ corresponds to one square matrix having a dimension of $Z \times Z$ within the extended matrix $H$, and includes two types of elements: an element indicating an all-zero square matrix, and an element indicating a cyclic shift value of the unit matrix. The extended matrix is the parity check matrix of a quasi-cyclic LDPC code.

Quasi-cyclic LDPC coding:

The quasi-cyclic LDPC code is a systematic code, i.e., an LDPC codeword [*u, p*] composed of a data sequence *u* to be coded and a check sequence *p*. The information sequence *u* of the LDPC code already known, and the LDPC coding process is a process of obtaining the check sequence *p*.

The LDPC coding process of a $M_b \times N_b$ base matrix is as follows.

First, the positions corresponding to the elements indicating the all-zero square matrix in the base matrix are replaced with the all-zero square matrix, and the positions corresponding to the elements indicating the cyclic shift value of the unit matrix are replaced with cyclic shift matrices of the unit matrix, so as to obtain the parity check matrix $H$ of the LDPC code, where the dimension of the all-zero square matrix or the unit matrix is equal to the lifting factor $Z$.

Secondly, the parity check matrix $H$ of the LDPC code may also be divided into two parts: a system block $H_u$ and a parity block $H_p$, where $H = [H_u, H_p]$, that is, $H_u$ is formed by the first $K_b \times Z$ columns (with a dimension of $(M_b \times Z) \times (K_b \times Z)$) of the parity check matrix $H$, and $H_p$ is formed by the last $M_b \times Z$ columns (with a dimension of $(M_b \times Z) \times (M_b \times Z)$) of the parity check matrix $H$, where $K_b = N_b - M_b$. The LDPC codeword satisfies the following equation:

$$H \cdot [\boldsymbol{u}, \boldsymbol{p}]^T = [H_u, H_p] \cdot [\boldsymbol{u}, \boldsymbol{p}]^T = 0$$

Furthermore,

$$H_p \boldsymbol{p}^T = H_u \boldsymbol{u}^T$$

Finally, the parity bit sequence $\boldsymbol{p}$ of the LDPC code may be calculated using the following formula to complete the LDPC coding:

$$\boldsymbol{p}^T = H_p^{-1} H_u \boldsymbol{u}^T$$

After obtaining the LDPC codeword [$\boldsymbol{u}$, $\boldsymbol{p}$], bits can be selected from (or rate match can be performed based on) the LDPC codeword [$\boldsymbol{u}$, $\boldsymbol{p}$] according to the required coding rate, so as to output a transmission bit sequence of the corresponding length. LDPC coding or decoding can be performed in parallel due to the inherent parallel nature of the LDPC code, resulting in higher coding or decoding throughput. In view of this, the embodiments of the present disclosure propose a constructing and coding method for a non-binary quasi-cyclic LDPC code to reduce coding complexity.

The embodiments of the present disclosure may operate on the network architecture shown in Fig. 2. Fig. 2 is a network architecture diagram of a coding method for a non-binary quasi-cyclic LDPC code according to some embodiments of the present disclosure. As shown in Fig. 2, the network architecture includes: a first transmission node and a second transmission node, wherein the second transmission node and the first transmission node may perform sending, receiving and related interaction of a wireless signal. The first transmission node performs non-binary LDPC coding on a bit sequence to be coded to obtain a codeword sequence to be sent, and after subjected to signal processing such as modulation, a transmission signal containing the codeword sequence to be sent is sent by the first transmission node to the second transmission node via a channel. The second transmission node performs signal processing, such as demodulating, on the received signal to obtain the codeword sequence information, and the second transmission node restores the information bit sequence by means of non-binary LDPC decoding.

In a feasible implementation, each of the first transmission node and the second transmission node may include but is not limited to one of the following devices: a Base Station (BS), an Access Point (AP), a node B, a generalized node B (gNB), a Radio Network Controller (RNC), an Evolved Node B (eNB), a Base Station Controller (BSC), a Base Transceiver Station (BTS), a Transceiver Function (TF), a radio router, a radio transceiver, a Basic Service Set (BSS), an Extended Service Set (ESS), or a Radio Base Station (RBS), which is not specifically limited in the embodiments of the present disclosure.

In a feasible implementation, the first transmission node and the second transmission node may be referred to as an access terminal, a User Equipment (UE), a subscriber unit, a subscriber station, a mobile site, a mobile station, a remote station, a remote terminal, a mobile device, a user terminal, a wireless communication device, a user agent or a user device. For example, the first transmission node may be a cellular telephone, a cordless telephone, a Session Initiation Protocol (SIP) phone, a Wireless Local Loop (WLL) station, a Personal Digital Assistant (PDA), a handheld device having a wireless communication function, a computing device or other processing device connected to a wireless modem, a vehicle-mounted device, a wearable device, a 5G network or a terminal device in a future 5G or beyond network, this is not specifically limited in the embodiments of the present disclosure.

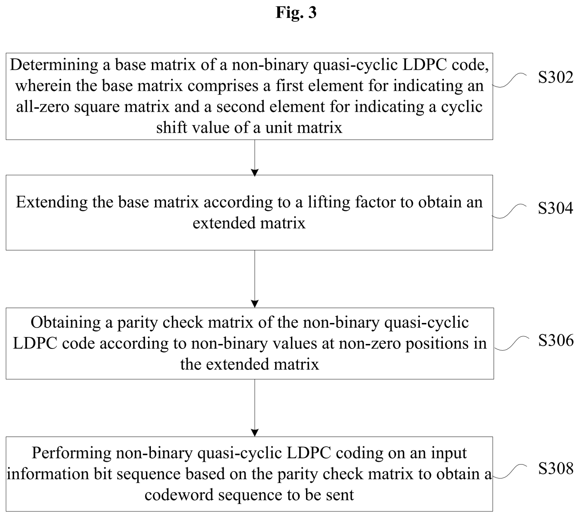

The present embodiment provides a coding method for a non-binary quasi-cyclic LDPC code operating on the computer terminal or network architecture. Fig. 3 is a flowchart of a coding method for a non-binary quasi-cyclic LDPC code according to some embodiments of the present disclosure. As shown in Fig. 3, the coding method includes the following operations S302 to S308.

In operation S302, a base matrix of a non-binary quasi-cyclic LDPC code is determined, wherein the base matrix includes a first element indicating an all-zero square matrix and a second element indicating a cyclic shift value of a unit matrix.

In an exemplary embodiment, the base matrix has a dimension of $Mb \times Nb$, and the first $M1$ rows and the first $N1$

columns of the base matrix form a first sub-matrix, wherein *Mb, Nb, M*1, and *N*1 are integers greater than 0, *M*1<*Mb,* and *N*1<*Nb.*

In an exemplary embodiment, the first *M*1 rows and the (*Kb*+1)-th to the *N*1-th columns of the base matrix form a first sub-matrix square, wherein *Kb* is the number of system columns, *Kb* =*N*1-*M*1, and a structural feature of the first sub-matrix square or the first sub-matrix square after row exchange includes at least one of: a diagonal structure, a double diagonal structure, an approximate double diagonal structure, a triangular matrix structure, or a combined structure.

The structural feature of the approximate double diagonal structure is: there exists one column that has a structural feature different from a corresponding column in the double diagonal structure, while the remaining columns have the same structural feature as the corresponding columns in the double diagonal structure, and the different structural feature of the one column is as follows: in the first sub-matrix square that has a double diagonal structure, the one column is a column (the first column or the last column) that contains only one second element and the remaining elements are the first elements; in the first sub-matrix square that has an approximate double diagonal structure, the one column has at least two second elements, where the first and last elements of the one column are the second elements, and the remaining positions in the one column can be either first or second elements.

The structural feature of the combined structure is: the first sub-matrix square is divided into four matrix blocks, two of which are square matrices, and the other two are rectangular matrices. The two square matrices have diagonal structures, double diagonal structures, approximate double diagonal structures, or triangular matrix structures, and at least one of the two rectangular matrices is a zero matrix. The structural forms of the aforementioned structural features are described in detail in subsequent embodiments.

In an exemplary embodiment, the first *M*1 rows and the last *Nb - N1* columns of the base matrix form a second sub-matrix, and the second sub-matrix is an all-zero matrix.

In an exemplary embodiment, the (*M*1 + 1)-th to the Mb-th rows of the base matrix and all columns of the base matrix form a third sub-matrix used for supporting non-binary quasi-cyclic LDPC coding with a low code rate.

In an exemplary embodiment, the third sub-matrix has a dimension of *M2 × Nb,* all rows and the last *M2* columns of the third sub-matrix form a third sub-matrix square, and a structural feature of the third sub-matrix square or the third sub-matrix square after row exchange includes at least one of: a diagonal structure, a double diagonal structure, an approximate double diagonal structure, a triangular matrix structure, or a combined structure, where *M2=Mb-M*1.

In operation S304, the base matrix is extended according to a lifting factor to obtain an extended matrix.

In an exemplary embodiment, the first element in the base matrix is extended into an all-zero square matrix having a dimension of $Z \times Z,$ and the second element in the base matrix is extended into a cyclic shift matrix $P^{h^b_{i,j}}$ of the unit matrix having a dimension of $Z \times Z,$ so as to obtain the extended matrix, wherein the base matrix has a dimension of *Mb × Nb,* the extended matrix has a dimension of $(Mb \times Z) \times (Nb \times Z)$, *Z* is the lifting factor, *Mb, Nb* and *Z* are all positive integers, $h^b_{i,j}$ is the second element, *i* is a row index of the second element in the base matrix, and *j* is a column index of the second element in the base matrix.

In operation S306, a parity check matrix of the non-binary quasi-cyclic LDPC code is obtained according to non-binary values at non-zero positions in the extended matrix.

In a practical implementation process, the parity check matrix of the non-binary quasi-cyclic LDPC code may be obtained according to non-binary values at non-zero positions in the extended matrix in different modes, which are specifically described as follows.

In an exemplary embodiment, the operation of obtaining the parity check matrix of the non-binary quasi-cyclic LDPC code according to the non-binary values at the non-zero positions in the extended matrix includes: determining the non-binary values at the non-zero positions in the extended matrix, and replacing elements at the non-zero positions in the extended matrix with corresponding non-zero elements in a non-binary Galois field value set to obtain the parity check matrix.

In an exemplary embodiment, the elements at the non-zero positions in the extended matrix are replaced with the corresponding non-zero elements in the non-binary Galois field value set according to a determination parameter, the determination parameter including at least one of: a size of the non-binary Galois field value set; a primitive element of the non-binary Galois field value set; the second element; the lifting factor of the base matrix; a row index of the second element in the base matrix; a column index of the second element in the base matrix; a row index of the non-zero positions in the extended matrix; or a column index of the non-zero positions in the extended matrix.

In an exemplary embodiment, the operation of obtaining the parity check matrix of the non-binary quasi-cyclic LDPC code according to the non-binary values at the non-zero positions in the extended matrix includes: replacing a cyclic shift matrix $P^{h^b_{i,j}}$ of the unit matrix having a dimension of $Z \times Z$ in the extended matrix with $x P^{h^b_{i,j}}$, wherein *x* is a non-zero element of a non-binary Galois field value set.

In an exemplary embodiment, the operation of obtaining the parity check matrix of the non-binary quasi-cyclic LDPC code according to the non-binary values at the non-zero positions in the extended matrix includes: replacing a cyclic shift matrix $P^{h_{i,j}^b}$ of the unit matrix having a dimension of $Z \times Z$ in the extended matrix with $P^{h_{i,j}^b} Z(x)$ to obtain the parity check matrix, wherein $Z(x) = \text{diag}\{x, \alpha x, \alpha^2 x, ..., \alpha^{Z-1} x\}$, diag {} denotes a diagonal matrix, $\alpha$ is a primitive element of a non-binary Galois field value set, and $x$ is a non-zero element of the non-binary Galois field value set.

In operation S308, non-binary quasi-cyclic LDPC coding is performed on an input information bit sequence based on the parity check matrix to obtain a codeword sequence to be sent.

By means of the operations, a base matrix of a non-binary quasi-cyclic LDPC code is determined, wherein the base matrix includes a first element indicating an all-zero square matrix and a second element indicating a cyclic shift value of a unit matrix; the base matrix is extended according to a lifting factor to obtain an extended matrix; a parity check matrix of the non-binary quasi-cyclic LDPC code is obtained according to non-binary values at non-zero positions in the extended matrix; and non-binary quasi-cyclic LDPC coding is performed on an input information bit sequence based on the parity check matrix to obtain a codeword sequence to be sent. The coding method solves the problems of high storage space requirements and complex coding processes of a non-binary LDPC code in some situations, and reduces the storage space of the non-binary LDPC code and simplifies the coding processes.

The entity for performing the foregoing operations may be, but is not limited to, a base station or a terminal.

Through the description of the foregoing embodiments, the coding method according to the foregoing embodiments may be implemented in a manner of combining software and a necessary universal hardware platform, and definitely may also be implemented through hardware. However, in many cases, the former is a preferred implementation. Based on such understanding, the essence of the technical solutions of the embodiments of the present disclosure or the part contributing to the related art may be embodied in the form of a software product. The computer software product is stored in a storage medium (such as a Read-Only Memory (ROM)/Random Access Memory (RAM), a magnetic disk, or an optical disk), and includes several instructions for enabling a terminal device (which may be a mobile phone, a computer, a server, a network device, or the like) to execute the coding method of the embodiments of the present disclosure.

A coding device for a non-binary quasi-cyclic LDPC code is also provided in the embodiments of the present disclosure. The coding device is used for implementing the described embodiment, and what has been described will not be elaborated. The term "module", as used hereinafter, is a combination of software and/or hardware capable of realizing a predetermined function. Although the coding device described in the following embodiment is preferably implemented by software, implementation of hardware or a combination of software and hardware is also possible and conceived.

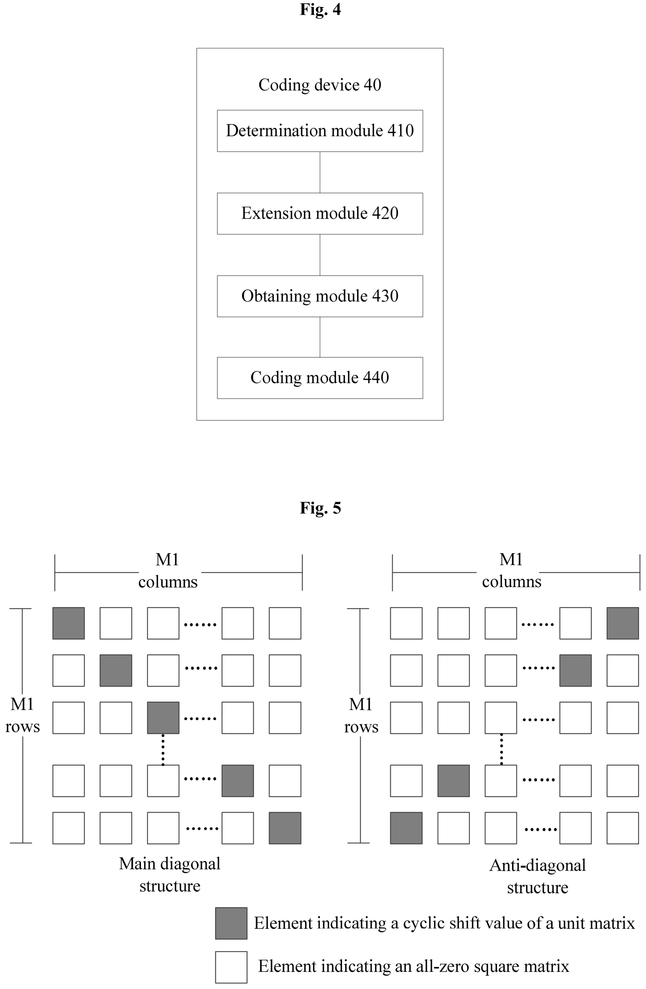

Fig. 4 is a block diagram of a coding device for a non-binary quasi-cyclic LDPC code according to some embodiments of the present disclosure. As shown in Fig. 4, the coding device 40 includes: a determination module 410 configured to determine a base matrix of a non-binary quasi-cyclic LDPC code, wherein the base matrix includes a first element indicating an all-zero square matrix and a second element indicating a cyclic shift value of a unit matrix; an extension module 420 configured to extend the base matrix according to a lifting factor to obtain an extended matrix; an obtaining module 430 configured to obtain a parity check matrix of the non-binary quasi-cyclic LDPC code according to non-binary values at non-zero positions in the extended matrix; and a coding module 440 configured to perform non-binary quasi-cyclic LDPC coding on an input information bit sequence based on the parity check matrix to obtain a codeword sequence to be sent.

It should be noted that each module may be implemented by software or hardware. The latter may be implemented in the following manner, but is not limited thereto. All the modules are located in a same processor; alternatively, the modules are located in different processors in an arbitrary combination.

The embodiments of the present disclosure also provide a computer-readable storage medium. The computer-readable storage medium stores a computer program, and the computer program, when executed by a processor, causes the processor to execute the operations in any one of the described method embodiments.

In an exemplary embodiment, the computer-readable storage medium may include, but is not limited to, any medium that can store a computer program, such as a Universal Serial Bus (USB) flash drive, an ROM, an RAM, a mobile hard disk, a magnetic disk, or an optical disc.

The embodiments of the present disclosure also provide an electronic device, including a memory and a processor. The memory stores a computer program. The processor is configured to run the computer program to execute the operations in any one of the method embodiments.

In an exemplary embodiment, the electronic device may further include a transmission device and an input/output device, wherein the transmission device is connected to the processor, and the input/output device is connected to the processor.

In this embodiment, reference may be made to the embodiments described in the foregoing embodiments and exemplary embodiments, and details are not repeatedly described herein in this embodiment.

Obviously, respective modules or operations in the above embodiments of the present disclosure may be implemented by a universal computing device, they may be centralized on a single computing device or distributed on a network composed of a plurality of computing devices, they can be implemented by program codes executable by a computing apparatus, and thus can be stored in a storage apparatus and executed by the computing apparatus. Furthermore, in some cases, the shown or described operations may be executed in an order different from that described here, or they are made into integrated circuit modules respectively, or a plurality of modules or operations therein are made into a single integrated circuit module for implementation. As such, the embodiments of the present disclosure are not limited to any particular hardware and software combination.

In order to enable those having ordinary skill in the art to better understand the technical solutions of the embodiments of the present disclosure, descriptions will be given below with reference to scenario-based embodiments.

Scenario-based embodiment 1

The present scenario-based embodiment provides a coding method for a non-binary quasi-cyclic LDPC code that can be applied to the network architecture shown in Fig. 2. The coding method includes the following operations I to IV.

I. Determining a base matrix *Hb:*

A dimension of the base matrix is $Mb \times Nb$, wherein $Mb$ and $Nb$ both are integers greater than 0. The base matrix *Hb* includes two types of elements: a first element indicating an all-zero square matrix, and a second element indicating a cyclic shift value of a unit matrix. The dimensions of the all-zero square matrix and the unit matrix are both $Z \times Z$, where $Z$ is a lifting factor, and $Z$ is a positive integer. The dimension of an extended matrix $H$ is $(Mb \times Z) \times (Nb \times Z)$, and the extended matrix is obtained by extending the base matrix based on the lifting factor. The element "1" in the extended matrix $H$ is replaced with a non-zero element in a non-binary Galois field value set to obtain the parity check matrix $H_q$ of the non-binary quasi-cyclic LDPC code.

In a first sub-matrix formed by the first $M1$ rows and the first $N1$ columns of the base matrix *Hb* of the non-binary quasi-cyclic LDPC code ($M1 = N1\text{-}Kb$, $Kb$ being the number of system columns), check columns of the first sub-matrix, i.e., a sub-matrix square formed by the first $M1$ rows and the $(Kb+1)$-th to the $N1$-th columns of the base matrix *Hb* or the sub-matrix square after being subjected to row exchange, have at least one of the following features: a diagonal structure, a double diagonal structure, an approximate double diagonal structure, a triangular matrix structure, or a combined structure.

The forms of the described structural features will be introduced below.

Fig. 5 is a schematic diagram of a diagonal structure according to a scenario-based embodiment of the present disclosure. As shown in Fig. 5, elements on a main diagonal or a anti-diagonal of a sub-matrix composed of check columns are elements indicating a cyclic shift value of a unit matrix, and all the other elements are elements indicating an all-zero square matrix.

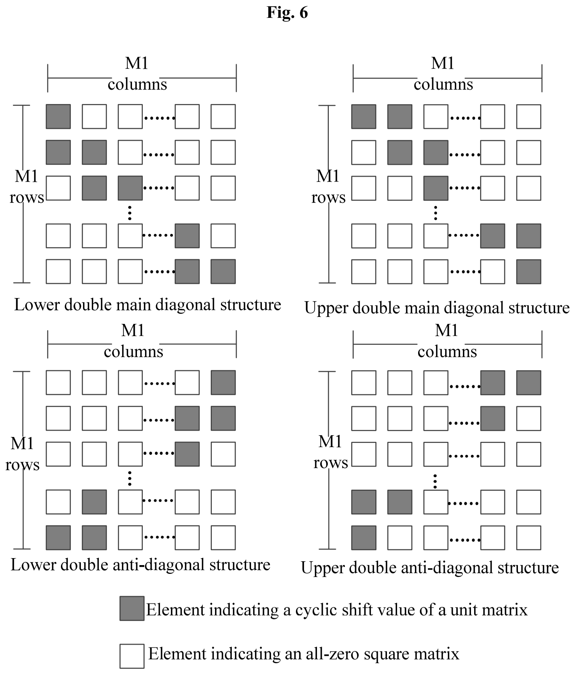

Fig. 6 is a schematic diagram of a double diagonal structure according to a scenario-based embodiment of the present disclosure. As shown in Fig. 6, elements on the main (anti-)diagonal of the sub-matrix composed of the check columns are elements indicating a cyclic shift value of a unit matrix, elements in the same columns as the elements on the main (anti-)diagonal with a row index value greater by 1 are also elements indicating a cyclic shift value of a unit matrix, while the remaining elements are used indicating an all-zero square matrix, this structure is referred to as a lower double main (anti-)diagonal structure. Alternatively, elements on the main (anti-)diagonal of the sub-matrix composed of the check columns are elements indicating a cyclic shift value of a unit matrix, elements in the same columns as the elements on the main (anti-)diagonal with a row index value smaller by 1 are also elements indicating a cyclic shift value of a unit matrix, while the remaining elements are used indicating an all-zero square matrix, this structure is referred to as an upper double main (anti-)diagonal structure.

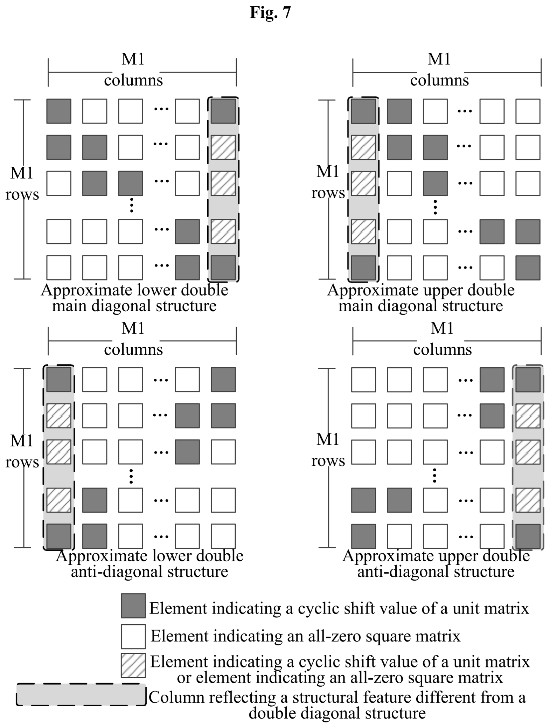

Fig. 7 is a schematic diagram of an approximate double diagonal structure according to a scenario-based embodiment of the present disclosure. As shown in Fig. 7, a sub-matrix composed of check columns has one column with a structural feature different from a corresponding column in a double diagonal structure, the remaining columns have the same structural feature as corresponding columns in the double diagonal structure, and the different structural feature of the one column is as follows: in the sub-matrix having a double diagonal structure, the one column is a column (the first column or the last column) that contains only one element indicating a cyclic shift value of a unit matrix and the remaining elements indicating an all-zero square matrix; and in the sub-matrix having an approximate double diagonal structure, the one column has at least two elements indicating the cyclic shift value of the unit matrix, wherein the first and last elements of the one column may indicate a cyclic shift value of the unit matrix, while the remaining elements of the one column may indicate an all-zero square matrix or indicate a cyclic shift value of the unit matrix. The above column is referred to as a column that reflects a structural feature difference from a double diagonal structure, as shown in Fig. 7. Further, a matrix obtained by extending the check columns having the approximate double diagonal structure based on the lifting factor has full rank. There are some typical forms. For instance, in the column that reflects a structural feature difference from the double diagonal structure, only one element indicating the cyclic shift value of the unit matrix has a different cyclic shift value from the remaining elements indicating the cyclic shift value of the unit matrix in that column. In contrast, in the other columns, the elements indicating the cyclic shift value of the unit matrix within the same column share the same cyclic shift value, and the sub-matrixes of size $Z \times Z$ over the Galois field, obtained by extending those elements with the same cyclic shift value based on the lifting factor, are also identical. For instance, in the column that reflects a structural feature difference from the double diagonal structure, there is always one element indicating the cyclic shift value of the unit matrix that has a different cyclic shift value from the remaining elements indicating the cyclic shift value of the unit matrix in that column, wherein every even number of the remaining elements indicating the cyclic shift values of the unit matrix in this column have the same cyclic shift value. In contrast, in the other columns, the elements indicating the cyclic shift value of the unit matrix within the same column share the same cyclic shift value, and the sub-matrixes of size $Z \times Z$ over the Galois field, obtained by extending those elements with the same cyclic shift value based on the lifting factor, are also identical. For instance, in the column that reflects a structural feature difference from the double diagonal structure, there are an odd number of elements indicating the cyclic shift value of the unit matrix that share the same cyclic shift value, and for the remaining elements indicating the cyclic shift value of the unit matrix in that column, every even number of these remaining elements have the same cyclic shift value. In contrast, in the other columns, the elements indicating the cyclic shift value of the unit matrix within the same column share the same cyclic shift value, and the sub-matrixes of size $Z \times Z$ over the Galois field, obtained by extending those elements with the same cyclic shift value based on the lifting factor, are also identical.

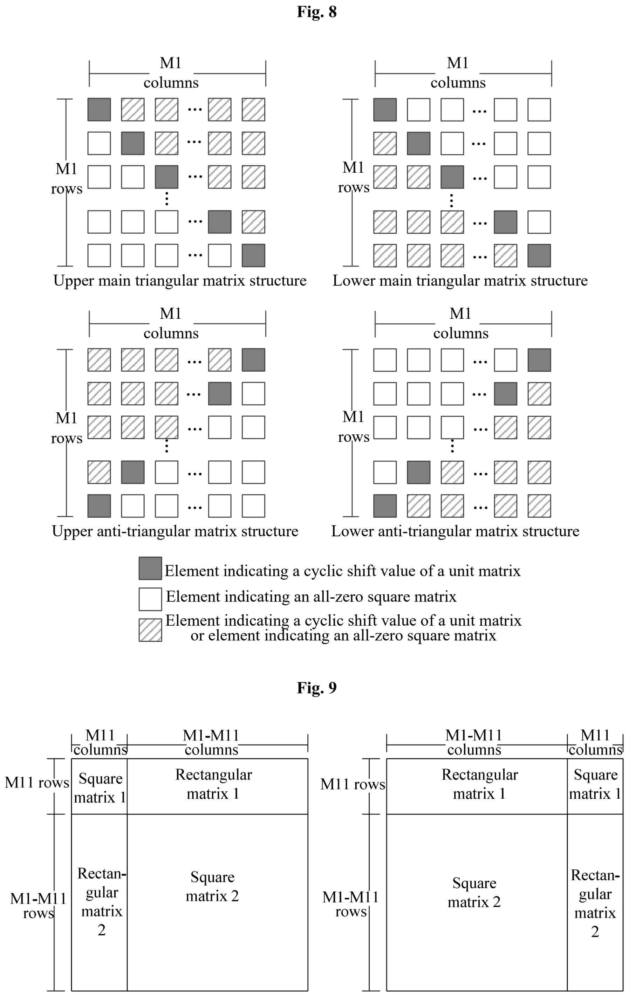

Fig. 8 is a schematic diagram of a triangular matrix structure according to a scenario-based embodiment of the present disclosure. As shown in Fig. 8, elements on a main (anti-)diagonal of a sub-matrix composed of check columns are elements indicating a cyclic shift value of a unit matrix, all the elements in the same column as the main (anti-)diagonal and with larger row indices are elements indicating an all-zero square matrix, and elements at remaining positions may be elements indicating a cyclic shift value of a unit matrix or elements indicating an all-zero square matrix, this structure is referred to as an upper main (anti-)triangular matrix structure. Alternatively, elements on a main (anti-)diagonal of a sub-matrix composed of check columns are elements indicating a cyclic shift value of a unit matrix, all the elements in the same column as the main (anti-)diagonal and with smaller row indices are elements indicating an all-zero square matrix, and elements at remaining positions may be elements indicating a cyclic shift value of a unit matrix or elements indicating an all-zero square matrix, this structure is referred to as a lower main (anti-)triangular matrix structure.

Fig. 9 is a schematic diagram of a combined structure according to a scenario-based embodiment of the present disclosure. As shown in Fig. 9, a $M1 \times M1$ matrix composed of check columns is divided into four sub-matrix blocks, wherein two square matrices have any of the described structural features, and at least one of the two rectangular matrices is an all-zero matrix.

In this scenario-based embodiment, a second sub-matrix formed by the first $M1$ rows and the last $Nb - N1$ columns of the base matrix of the non-binary quasi-cyclic LDPC code is an all-zero matrix. The $(M1+1)$-th to the $Mb$-th rows (i.e., the last $Mb - M1$ rows) and all columns of the base matrix of the non-binary quasi-cyclic LDPC code form a third sub-matrix that is used for supporting non-binary quasi-cyclic LDPC coding with a low code rate. The third sub-matrix has a dimension of $M2 \times Nb$, where $M2 = Mb - M1$. All rows and the last $M2$ columns of the third sub-matrix have at least one of the following structural features, or have at least one of the following structural features after row exchange: a diagonal structure, a double diagonal structure, an approximate double diagonal structure, a triangular matrix structure, or a combined structure.

II. Determining the extended matrix $H$ according to the base matrix and the lifting factor:

The base matrix is extended based on the lifting factor to obtain the extended matrix $H$. Specifically, the element indicating the all-zero square matrix in the base matrix $Hb$ is extended into the all-zero square matrix having a dimension of $Z \times Z$, and the element indicating a cyclic shift value of a unit matrix in the base matrix $Hb$ is extended into a cyclic shift matrix of a unit matrix having a dimension of $Z \times Z$. Further, assuming that the element indicating the cyclic shift value of the unit matrix, which is located at the $i$-th row and $j$-th column of the base matrix $Hb$, is $h_{i,j}^{b}$, and the position index in the extended matrix $H$ of an element "1" of a square matrix extended from this element $h_{i,j}^{b}$ is denoted as $(m, n)$ (the indices in the embodiments of the present disclosure all start from 0 by default), then $m = i * Z + it$,

$$n = j * Z + mod(mod(h_{i,j}^{b}, Z) + it, Z),$$ where $it$ is the row index of the element "1" in the corresponding $Z \times Z$ cyclic shift matrix of the unit matrix, and $mod(x, y)$ represents a remainder of $x$ divided by $y$. Here, the superscript $b$ in $h_{i,j}^{b}$ acts only as a marker, indicating that the element is an element in the base matrix $Hb$ and has no substantial physical meaning.

III. Determining non-binary values at non-zero positions in the extended matrix $H$ to obtain a parity check matrix $H_q$ of the non-binary quasi-cyclic LDPC code:

After the base matrix is extended based on the lifting factor to obtain the extended matrix $H$, the non-zero element "1" of the extended matrix $H$ is replaced with a non-zero element in a non-binary Galois field value set, so as to obtain the parity check matrix $H_q$ of the non-binary quasi-cyclic LDPC code. It is assumed that the set Galois field (GF) is GF(q), a primitive element of the Galois field is $\alpha$ and a corresponding primitive polynomial is $p(x)$, then the replacement method for the non-zero element is to replace the element "1" in the extended matrix $H$ with a certain non-zero element in the Galois field non-zero element set {1,2,3, ..., q-1}. There is a one-to-one mapping relationship between an element value of the non-zero element in the Galois field and a power of a primitive element. In some cases, a non-zero element value corresponding to the $i$-th power $\alpha^i$ of the primitive element is a decimal representation of a coefficient of a residue polynomial obtained by dividing $X^i$ by the primitive polynomial $p(x)$. For example, given that the primitive polynomial of the Galois field GF(8) is $p(x) = x^3 + x + 1$, then the correspondence between the powers of the primitive element and the values of the non-zero elements is as shown in Table 1.

Table 1 Correspondence between power of $\alpha$ and non-zero elements generated by GF(8) under the primitive polynomial $p(x) = x^3 + x + 1$

| Power of $\alpha$ | Residue polynomial | Polynomial coefficient | Non-zero element |
|---|---|---|---|
| $\alpha^0$ | 1 | 001 | 1 |
| $\alpha^1$ | $\alpha$ | 010 | 2 |
| $\alpha^2$ | $\alpha^2$ | 100 | 4 |
| $\alpha^3$ | $\alpha + 1$ | 011 | 3 |
| $\alpha^4$ | $\alpha^2 + \alpha$ | 110 | 6 |
| $\alpha^5$ | $\alpha^2 + \alpha + 1$ | 111 | 7 |
| $\alpha^6$ | $\alpha^2 + 1$ | 101 | 5 |

In the method for replacing the element "1" in the extended matrix $H$ with a certain non-zero element in the Galois field non-zero element set {1, 2, 3, ..., q-1}, the non-zero element is determined at least by one of the following determination parameters: a size $q$ of the Galois field; the primitive element $\alpha$ of the Galois field; the element $h_{i,j}^b$ indicating the cyclic shift value of the unit matrix; the lifting factor $Z$; a row index $i$ (in the base matrix $Hb$) of the element $h_{i,j}^b$ indicating the cyclic shift value of the unit matrix; a column index $j$ (in the base matrix $Hb$) of the element $h_{i,j}^b$ indicating the cyclic shift value of the unit matrix; a row index $m$ of the element "1" to be replaced in the extended matrix $H$; or a column index $n$ of the element "1" to be replaced in the extended matrix $H$.

In this scenario-based embodiment, three methods for replacing the element "1" in the extended matrix $H$ with a certain non-zero element in the Galois field non-zero element set {1, 2, 3, ..., q-1} are discussed as follows:

(1) Replacing the cyclic shift matrix $P^{h_{i,j}^b}$ ( $h_{i,j}^b$ is the element indicating the cyclic shift value of the unit matrix in the base matrix $Hb$) of each unit matrix having a dimension of $Z \times Z$ in the extended matrix H with $xP^{h_{i,j}^b}$, wherein $x$ is a certain element in the Galois field non-zero element set {1, 2, 3,..., q-1}, and is determined at least by one of the described determination parameters. According to different determination parameters, $x$ has different forms, for example:

$$x = mod(h_{i,j}^b, q - 1) + 1$$, wherein the addition and subtraction operations are operations in a field of real numbers, and $h_{i,j}^b$, $q$, and 1 are all integers in the field of real numbers; or,

$$x = \alpha^{mod(h_{i,j}^b, q-1)}$$, wherein $\alpha$ is a primitive element in GF(q), the addition and subtraction operations are operations in the field of real numbers, and $h_{i,j}^b$ , $q$, and 1 are all integers in the field of real numbers; or,

$x = mod(|i \pm j|, q - 1) + 1$, wherein $i$ and $j$ respectively represent a row index and a column index of $h_{i,j}^b$ in the base matrix $Hb$, $| \cdot |$ represents an absolute value operation, the addition and subtraction operations are operations in the field of real numbers, and $i, j, q,$ and 1 are all integers in the field of real numbers; or,

$x = \alpha^{mod(|i \pm j|, q-1)}$, wherein $\alpha$ is a primitive element in GF(q), $i$ and $j$ respectively represent a row index and a column index of $h_{i,j}^b$ in the base matrix $Hb$, $| \cdot |$ represents an absolute value operation, the addition and subtraction operations are operations in the field of real numbers, and $i, j, q,$ and 1 are all integers in the field of real numbers; or,

$x = mod(|i \pm n_r|, q - 1) + 1$, wherein $i$ represents a row index of $h_{i,j}^b$ in the base matrix $Hb$, $n_r$ represents a column index in the extended matrix $H$ of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $i, n_r, q,$ and 1 are all integers in the field of real numbers; or,

$x = \alpha^{mod(|i \pm n_r|,q-1)}$, wherein $\alpha$ is a primitive element in GF(q), $i$ represents a row index of $h_{i,j}^b$ in the base matrix $Hb$, $n_r$ represents a column index in the extended matrix $H$ of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $i, n_r, q,$ and 1 are all integers in the field of real numbers; or,

$x = mod(|j \pm m_r|, q - 1) + 1$, wherein $j$ represents a column index of $h_{i,j}^b$ in the base matrix $Hb$, $m_r$ represents a row index in the extended matrix $H$ of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $j, m_r, q,$ and 1 are all integers in the field of real numbers; or,

$x = \alpha^{mod(|j \pm mr|,q-1)}$, wherein $\alpha$ is a primitive element in GF(q), $j$ represents a column index of $h_{i,j}^b$ in the base matrix $Hb$, $m_r$ represents a row index in the extended matrix $H$ of the element "1" to be replaced in the r-th row of the cyclic shift matrix $P^{h_{i,j}^b}$ of the unit matrix ( a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $j, m_r, q,$ and 1 are all integers in the field of real numbers; or,

$x = mod(|m_r \pm n_r|, q - 1) + 1$, wherein $m_r$ and $n_r$ respectively represent a row index and a column index in the extended matrix $H$ of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $m_r, n_r, q,$ and 1 are all integers in the field of real numbers; or,

$x = \alpha^{mod(|mr \pm nr|,g-1)}$, wherein $\alpha$ is a primitive element in GF(q), $m_r$ and $n_r$ respectively represent a row index and a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), | · | represents an absolute value operation, the addition and subtraction operations are operations in the field of real numbers, and $m_r$, $n_r$, $q$, and 1 are all integers in the field of real numbers; or,

$x = mod(m_r, q - 1) + 1$, wherein $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $m_r$, $q$, and 1 are all integers in the field of real numbers; or,

$x = \alpha^{mod(m_r, q-1)}$, wherein $\alpha$ is a primitive element in GF(q), $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), | · | represents an absolute value operation, the subtraction operation is an operation in the field of real numbers, and $m_r$, $q$, and 1 are all integers in the field of real numbers; or,

$x = mod(n_r, q - 1) + 1$, wherein $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $n_r$, $q$, and 1 are all integers in the field of real numbers; or,

$x = \alpha^{mod(n_r, q-1)}$, wherein $\alpha$ is a primitive element in GF(q), $n_r$ represents a column index in the extended matrix $H$ of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), | · | represents an absolute value operation, the subtraction operation is an operation in the field of real numbers, and $n_r$, $q$, and 1 are all integers in the field of real numbers.

(2) Replacing the cyclic shift matrix $P^{h_{i,j}^b}$ of each unit matrix having a dimension of $Z \times Z$ in the extended matrix H with $P^{h_{i,j}^b} Z(x)$, wherein $Z(x) = diag\{x, \alpha x, \alpha^2 x, ..., \alpha^{Z-1}x\}$, diag{} denotes a diagonal matrix, $\alpha$ is a primitive element in GF(q), and $x$ is a certain element in a Galois field non-zero element set {1, 2, 3, ..., q-1}, which is determined at least by one of the described parameters, for example:

$$x = mod\left(h_{i,j}^b, q - 1\right) + 1,$$ wherein the addition and subtraction operations are operations in a field of real numbers, and $h_{i,j}^b$, $q$, and 1 are all integers in the field of real numbers; or,

$$x = \alpha^{mod(h_{i,j}^b, q-1)},$$ wherein $\alpha$ is a primitive element in GF(q), the addition and subtraction operations are operations in the field of real numbers, and $h_{i,j}^b$, $q$, and 1 are all integers in the field of real numbers; or,

$x = mod(|i \pm j|, q - 1) + 1$, wherein $i$ and $j$ respectively represent a row index and a column index of $h_{i,j}^b$ in the base matrix $Hb$, | · | represents an absolute value operation, the addition and subtraction operations are operations in the field of real numbers, and $i$, $j$, $q$, and 1 are all integers in the field of real numbers; or,

$x = \alpha^{mod(|i \pm j|, q-1)}$, wherein $\alpha$ is a primitive element in GF(q), $i$ and $j$ respectively represent a row index and a column index of $h_{i,j}^b$ in the base matrix $Hb$, | · | represents an absolute value operation, the addition and subtraction operations are operations in the field of real numbers, and $i$, $j$, $q$, and 1 are all integers in the field of real numbers;

or,

$x = mod(|i \pm n_r|, q - 1) + 1$, $i$ represents a row index of $h_{i,j}^b$ in the base matrix $Hb$, $n_r$ represents a column index in the extended matrix $H$ of the element "1" in the $r$-th row to be replaced in the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $i, n_r, q,$ and 1 are all integers in the field of real numbers; or,

$x = \alpha^{mod(|i \pm n_r|, q-1)}$, $\alpha$ is $\alpha$ primitive element in GF(q), $i$ represents a row index of $h_{i,j}^b$ in the base matrix $Hb$, $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $i, n_r, q,$ and 1 are all integers in the field of real numbers; or,

$x = mod(|j \pm m_r|, q - 1) + 1$, wherein $j$ represents a column index of $h_{i,j}^b$ in the base matrix $Hb$, $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $j, m_r, q,$ and 1 are all integers in the field of real numbers; or,

$x = \alpha^{mod(|j \pm m_r|, q-1)}$, wherein $\alpha$ is a primitive element in GF(q), $j$ represents a column index of $h_{i,j}^b$ in the base matrix $Hb$, $m_r$ represents a row index in the extended matrix $H$ of the element "1" to be replaced in the r-th row of in the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $j, m_r, q,$ and 1 are all integers in the field of real numbers; or,

$x = mod(|m_r \pm n_r|, q - 1) + 1$, wherein $m_r$ and $n_r$ respectively represent a row index and a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $m_r, n_r, q,$ and I are all integers in the field of real numbers; or,

$x = \alpha^{mod(|m_r \pm n_r|, q-1)}$, wherein $\alpha$ is a primitive element in GF(q), $m_r$ and $n_r$ respectively represent a row index and a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $m_r, n_r, q,$ and 1 are all integers in the field of real numbers; or,

$x = mod(m_r, q - 1) + 1$, wherein $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $m_r, q,$ and 1 are all integers in the field of real numbers; or,

$x = \alpha^{mod(m_r, q-1)}$, wherein $\alpha$ is a primitive element in GF(q), $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $|\cdot|$ represents an absolute value operation, the subtraction operation is an operation in the field of real numbers, and $m_r$, $q$, and 1 are all integers in the field of real numbers; or,

$x = mod(n_r, q - 1) + 1$, wherein $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $n_r$, $q$, and 1 are all integers in the field of real numbers; or,

$x = \alpha^{mod(|n_r, q-1|)}$, wherein $\alpha$ is a primitive element in GF(q), $n_r$ represents a column index in the extended matrix $H$ of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), $|\cdot|$ represents an absolute value operation, the subtraction operation is an operation in the field of real numbers, and $n_r$, $q$, and 1 are all integers in the field of real numbers.

(3) Replacing each non-zero element "1" in the extended matrix $H$ with a non-zero element in a Galois field value set, wherein the non-zero element is determined by at least one of the described parameters, for example:

$h_{m,n} = mod(|m \pm n|, q - 1) + 1$, wherein m and $n$ respectively represent a row index and a column index in the extended matrix $H$ of the element "1" to be replaced by a non-zero element $h_{m,n}$, $|\cdot|$ represents an absolute value operation, the addition and subtraction operations are operations in the field of real numbers, and $m$, $n$, $q$, and 1 are all integers in the field of real numbers; or,

$h_{m,n} = \alpha^{mod(|m \pm n|, q-1)}$, $\alpha$ is a primitive element in GF(q), m and $n$ respectively represent a row index and a column index in the extended matrix $H$ of the element "1" to be replaced by the non-zero element $h_{m,n}$, $|\cdot|$ represents an absolute value operation, the addition and subtraction operations are operations in the field of real numbers, and $m$, $n_r$ $q$, and 1 are all integers in the field of real numbers; or,

$h_{m,n} = mod(n, q - 1) + 1$, wherein $n$ represents a column index in the extended matrix $H$ of the element "1" to be replaced by the non-zero element $h_{m,n}$, the addition and subtraction operations are operations in the field of real numbers, and $n$, $q$, and 1 are all integers in the field of real numbers; or,

$h_{m,n} = \alpha^{mod(n, q-1)}$, wherein $\alpha$ is a primitive element in GF(q), $n$ represents a column index in the extended matrix $H$ of the element "1" to be replaced by the non-zero element $h_{m,n}$, the subtraction operation is an operation in the field of real numbers, and $n_r$ $q$, and 1 are all integers in the field of real numbers; or,

$h_{m,n} = mod(|n \pm i|, q - 1) + 1$, wherein $n$ represents a column index in the extended matrix $H$ of the element "1" to be replaced by the non-zero element $h_{m,n}$, $i$ represents a row index in the base matrix $Hb$ of the element $h_{i,j}^b$ indicating the cyclic shift value of the unit matrix corresponding to the cyclic shift matrix $P^{h_{i,j}^b}$ of the unit matrix having a dimension of $Z \times Z$ where the element "1" to be replaced by the non-zero element $h_{m,n}$ is located, $|\cdot|$ represents an absolute value operation, the addition and subtraction operations are operations in the field of real numbers, and $n$, $i$, $q$, and l are all integers in the field of real numbers; or,

$h_{m,n} = \alpha^{mod(|n \pm i|, q-1)}$, wherein $\alpha$ is a primitive element in GF(q), $n$ represents a column index in the extended matrix $H$ of the element "1" to be replaced by the non-zero element $h_{m,n}$, $i$ represents a row index in the base matrix $Hb$ of the element $h_{i,j}^b$ indicating the cyclic shift value of the unit matrix corresponding to the cyclic shift matrix $P^{h_{i,j}^b}$ of the unit matrix having a dimension of $Z \times Z$ where the element "1" to be replaced by the non-zero element $h_{m,n}$ is located, $|\cdot|$ represents an absolute value operation, the addition and subtraction operations are operations in the field of real numbers, and $n$, $i$, $q$, and 1 are all integers in the field of real numbers; or,

$h_{m,n} = mod(m, q - 1) + 1$, wherein m represents a row index in the extended matrix $H$ of the element "1" to be replaced by the non-zero element $h_{m,n}$, the addition and subtraction operations are operations in the field of real numbers, and $m$, $q$, and 1 are all integers in the field of real numbers; or,

$h_{m,n} = \alpha^{mod(m,q-1)}$, wherein $\alpha$ is a primitive element in GF(q), $m$ represents a row index in the extended matrix $H$ of the element "1" to be replaced by the non-zero element $h_{m,n}$, the subtraction operation is an operation in the field of real numbers, and $m$, $q$, and 1 are all integers in the field of real numbers; or,

$h_{m,n} = mod(|m \pm j|, q - 1) + 1$, wherein $m$ represents a row index in the extended matrix $H$ of the element "1" to be replaced by the non-zero element $h_{m,n}$, $j$ represents a column index in the base matrix $Hb$ of the element $h_{i,j}^{b}$ indicating the cyclic shift value of the unit matrix corresponding to the cyclic shift matrix $P^{h_{i,j}^{b}}$ of the unit matrix having a dimension of $Z \times Z$ where the element "1" to be replaced by the non-zero element $h_{m,n}$ is located, $| \cdot |$ represents an absolute value operation, the addition and subtraction operations are operations in the field of real numbers, and m, $j$, $q$, and 1 are all integers in the field of real numbers; or,

$h_{m,n} = \alpha^{mod(|m \pm j|, q-1)}$, wherein $\alpha$ is a primitive element in the GF(q), m represents a row index in the extended matrix $H$ of the element "1" to be replaced by the non-zero element $h_{m,n}$, $j$ represents a column index in the base matrix $Hb$ of the element $h_{i,j}^{b}$ indicating the cyclic shift value of the unit matrix corresponding to the cyclic shift matrix $P^{h_{i,j}^{b}}$ of the unit matrix having a dimension of $Z \times Z$ where the element "1" to be replaced by the non-zero element $h_{m,n}$ is located, $| \cdot |$ represents an absolute value operation, the addition and subtraction operations are operations in the field of real numbers, and m, $j$, $q$, and 1 are all integers in the field of real numbers.

IV. Performing non-binary LDPC coding on an input information bit sequence according to the parity check matrix $H_q$ to obtain a codeword sequence to be sent.

Scenario-based embodiment 2

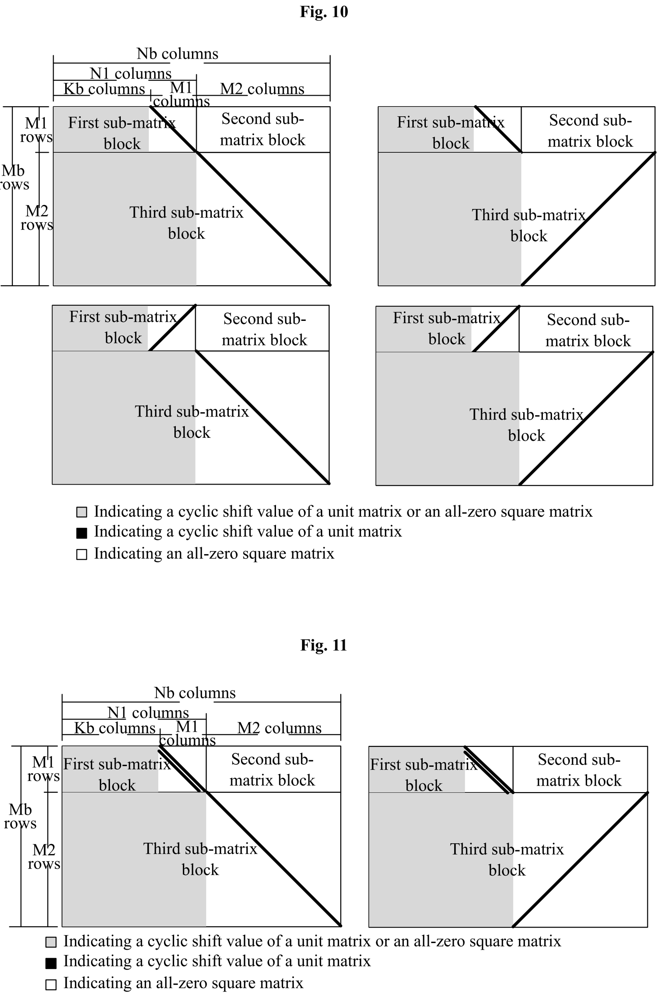

Fig. 10 is a schematic diagram of a structure of a base matrix according to a scenario-based embodiment of the present disclosure. As shown in Fig. 10, in a first sub-matrix formed by the first M1 rows and the first N1 columns of a base matrix $Hb$ of a non-binary quasi-cyclic LDPC code *(M1 = N1 - Kb, Kb* being the number of system columns), check columns of the first sub-matrix, i.e., a M1 $\times$M1 square matrix formed by the first M1 rows and the (Kb+1)-th to the N1-th columns of the base matrix $Hb$, have a diagonal structure, or have a diagonal structure after row exchange. A second sub-matrix formed by the first M1 rows and the last $N_b$ - N1 rows of the base matrix of the non-binary quasi-cyclic LDPC code is an all-zero matrix. The ( M1 + 1)-th to the $M_b$-th rows (i.e., the last $M_b$ - M1 rows) and all columns of the base matrix of the non-binary quasi-cyclic LDPC code form a third sub-matrix that is used for supporting non-binary quasi-cyclic LDPC coding with a low rate. The third sub-matrix has a dimension of $M2 \times N_b$, where $M2=M_b$-M1, and an $M2 \times M2$ square composed of all the rows and the last M2 columns of the third sub-matrix has a diagonal structure, or has a diagonal structure after row exchange.

The base matrix shown in Fig. 10 may be extended based on a lifting factor to obtain an extended matrix $H$. Specifically, each element indicating an all-zero square matrix in the base matrix $Hb$ is extended into an all-zero square matrix having a dimension of $Z \times Z$, and each element indicating a cyclic shift value of a unit matrix in the base matrix $Hb$ is extended into a cyclic shift matrix of the unit matrix having a dimension of $Z \times Z$. Further, assuming that the element indicating the cyclic shift value of the unit matrix, which is located at the $i$-th row and $j$-th column of the base matrix $Hb$, is

$h_{i,j}^{b}$, and the position index in the extended matrix $H$ of an element "1" of a square matrix extended from this element $h_{i,j}^{b}$ is denoted as $(m, n)$ (the indices in the embodiments of the present disclosure all start from 0 by default), then $m = i * Z + it$,

$n = j * Z + mod(mod(h_{i,j}^{b}, Z) + it, Z)$, where *it* is the row index of the element "1" in the corresponding $Z \times Z$ cyclic shift matrix of the unit matrix, and $mod(x, y)$ represents a remainder of $x$ divided by $y$.

After the base matrix is extended based on the lifting factor to obtain the extended matrix $H$, the non-zero element "1" of the extended matrix $H$ is replaced with a non-zero element in a non-binary Galois field value set, so as to obtain the parity check matrix $H_q$ of the non-binary quasi-cyclic LDPC code. It is assumed that the set Galois field (GF) is GF(q), a primitive element of the Galois field is $\alpha$ and a corresponding primitive polynomial is *p(x),* then the replacement method for the non-zero element is to replace the element "1" in the extended matrix $H$ with a certain non-zero element in the Galois field non-zero element set {1,2,3, ..., q-1}. There is a one-to-one mapping relationship between an element value of the non-zero element in the Galois field and a power of a primitive element. In some cases, a non-zero element value corresponding to the $i$-th power $\alpha^i$ of the primitive element is a decimal representation of a coefficient of a residue polynomial obtained by dividing $X^i$ by the primitive polynomial $p(x)$. In the method for replacing the element "1" in the extended matrix $H$ with a certain non-zero element in the Galois field non-zero element set {1, 2, 3, ..., q-1}, the non-zero element is determined at least by one of the following determination parameters: a size $q$ of the Galois field; the primitive element $\alpha$ of the Galois field; the element $h_{i,j}^b$ indicating the cyclic shift value of the unit matrix; the lifting factor $Z$; a row index $i$ (in the base matrix $Hb$) of the element $h_{i,j}^b$ indicating the cyclic shift value of the unit matrix; a column index $j$ (in the base matrix $Hb$) of the element $h_{i,j}^b$ indicating the cyclic shift value of the unit matrix; a row index $m$ of the element "1" to be replaced in the extended matrix $H;$ or a column index $n$ of the element "1" to be replaced in the extended matrix $H$.

According to different structure features of the base matrix in the present scenario-based embodiment, in this scenario-based embodiment, three methods for replacing the element "1" in the extended matrix $H$ with a certain non-zero element in the Galois field non-zero element set {1, 2, 3, ..., q-1} are discussed as follows:

(1) Replacing the cyclic shift matrix $P^{h_{i,j}^b}$ ( $h_{i,j}^b$ is the element indicating the cyclic shift value of the unit matrix in the base matrix $Hb$) of each unit matrix having a dimension of $Z \times Z$ in the extended matrix H with $x P^{h_{i,j}^b}$, wherein $x$ is a certain element in the Galois field non-zero element set {1, 2, 3,..., q-1}, and is determined at least by one of the described determination parameters. For example:

$$x = mod\left(h_{i,j}^b, q - 1\right) + 1$$, wherein the addition and subtraction operations are operations in a field of real numbers, and $h_{i,j}^b$, $q$, and 1 are all integers in the field of real numbers; or,

$$x = \alpha^{mod(h_{i,j}^b, q-1)}$$, wherein $\alpha$ is a primitive element in GF(q), the addition and subtraction operations are operations in the field of real numbers, and $h_{i,j}^b$, $q$, and 1 are all integers in the field of real numbers; or,

$x = mod(|i \pm j|, q - 1) + 1$, wherein $i$ and $j$ respectively represent a row index and a column index of $h_{i,j}^b$ in the base matrix $Hb$, $|\cdot|$ represents an absolute value operation, the addition and subtraction operations are operations in the field of real numbers, and $i, j, q,$ and 1 are all integers in the field of real numbers; or,

$x = \alpha^{mod(|i \pm j|, q-1)}$, wherein $\alpha$ is a primitive element in GF(q), $i$ and $j$ respectively represent a row index and a column index of $h_{i,j}^b$ in the base matrix $Hb$, $|\cdot|$ represents an absolute value operation, the addition and subtraction operations are operations in the field of real numbers, and $i, j, q,$ and 1 are all integers in the field of real numbers; or,

$x = mod(|i \pm n_r|, q - 1) + 1$, wherein $i$ represents a row index of $h_{i,j}^b$ in the base matrix $Hb$, $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $|\cdot|$ represents an absolute value operation, the addition and subtraction operations are operations in the field of real numbers, and $i, n_r, q,$ and 1 are all integers in the field of real numbers; or,

$x = \alpha^{mod(|i \pm n_r|, q-1)}$, wherein $\alpha$ is a primitive element in GF(q), $i$ represents a row index of $h_{i,j}^b$ in the base matrix $Hb$, $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $|\cdot|$ represents an absolute value operation, the addition and subtraction operations are operations in the field of real numbers, and $i, n_r, q,$ and 1 are all integers in the field of real numbers; or,

$x = mod(|j \pm m_r|, q - 1) + 1$, wherein $j$ represents a column index of $h_{i,j}^b$ in the base matrix $Hb$, $m_r$ represents a row index in the extended matrix $H$ of the element "1" to be replaced in the $r$-th row of the cyclic shift matrix $p^{h_{i,j}^b}$ of the unit matrix (a selection rule of $r$ is agreed by a receiving end and a sending end of a communication system, for example, $r$ may be fixed as 0), $|\cdot|$ represents an absolute value operation, the addition and subtraction operations are operations in the field of real numbers, and $j$, $m_r$, $q$, and 1 are all integers in the field of real numbers; or,

$x = \alpha^{mod(|j\pm m_r|, q-1)}$, wherein $\alpha$ is a primitive element in GF(q), $j$ represents a column index of $h_{i,j}^b$ in the base matrix $Hb$, $m_r$ represents a row index in the extended matrix $H$ of the element "1" to be replaced in the $r$-th row of the cyclic shift matrix $p^{h_{i,j}^b}$ of the unit matrix ( a selection rule of $r$ is agreed by a receiving end and a sending end of a communication system, for example, $r$ may be fixed as 0), $|\cdot|$ represents an absolute value operation, the addition and subtraction operations are operations in the field of real numbers, and $j$, $m_r$, $q$, and 1 are all integers in the field of real numbers; or,

$x = mod(|m_r \pm n_r|, q - 1) + 1$, wherein $m_r$ and $n_r$ respectively represent a row index and a column index in the extended matrix $H$ of the element "1" to be replaced in the $r$-th row of the cyclic shift matrix $p^{h_{i,j}^b}$ of the unit matrix (a selection rule of $r$ is agreed by a receiving end and a sending end of a communication system, for example, $r$ may be fixed as 0), $|\cdot|$ represents an absolute value operation, the addition and subtraction operations are operations in the field of real numbers, and $m_r$, $n_r$, $q$, and 1 are all integers in the field of real numbers; or,

$x = \alpha^{mod(|m_r \pm n_r|, q-1)}$, wherein $\alpha$ is a primitive element in GF(q), $m_r$ and $n_r$ respectively represent a row index and a column index in the extended matrix $H$ of the element "1" to be replaced in the r-th row of the cyclic shift matrix $p^{h_{i,j}^b}$ of the unit matrix (a selection rule of $r$ is agreed by a receiving end and a sending end of a communication system, for example, $r$ may be fixed as 0), $|\cdot|$ represents an absolute value operation, the addition and subtraction operations are operations in the field of real numbers, and $m_r$, $n_r$, $q$, and 1 are all integers in the field of real numbers; or,

$x = mod(m_r, q - 1) + 1$, wherein $m_r$ represents a row index in the extended matrix $H$ of the element "1" to be replaced in the $r$-th row of the cyclic shift matrix $p^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $m_r$, $q$, and 1 are all integers in the field of real numbers; or,

$x = \alpha^{mod(|m_r, q-1)}$, wherein $\alpha$ is a primitive element in GF(q), $m_r$ represents a row index in the extended matrix $H$ of the element "1" to be replaced in the $r$-th row of the cyclic shift matrix $p^{h_{i,j}^b}$ of the unit matrix (a selection rule of $r$ is agreed by a receiving end and a sending end of a communication system, for example, $r$ may be fixed as 0), $|\cdot|$ represents an absolute value operation, the subtraction operation is an operation in the field of real numbers, and $m_r$, $q$, and 1 are all integers in the field of real numbers; or,

$x = mod(n_r, q - 1) + 1$, wherein $n_r$ represents a column index in the extended matrix $H$ of the element "1" to be replaced in the $r$-th row of the cyclic shift matrix $p^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $n_r$, $q$, and 1 are all integers in the field of real numbers; or,

$x = \alpha^{mod(n_r, q-1)}$, wherein $\alpha$ is a primitive element in GF(q), $n_r$ represents a column index in the extended matrix $H$ of the element "1" to be replaced in the r-th row of the cyclic shift matrix $p^{h_{i,j}^b}$ of the unit matrix (a selection rule of $r$ is agreed by a receiving end and a sending end of a communication system, for example, $r$ may be fixed as 0), $|\cdot|$ represents an absolute value operation, the subtraction operation is an operation in the field of real numbers, and $n_r$, $q$, and 1 are all integers in the field of real numbers.

(2) Replacing the cyclic shift matrix $P^{h_{i,j}^b}$ of each unit matrix having a dimension of $Z \times Z$ in the extended matrix H with $P^{h_{i,j}^b} Z(x)$, wherein $Z(x) = \text{diag}\{x, \alpha x, \alpha^2 x, \ldots, \alpha^{Z-1}x\}$, diag{} denotes a diagonal matrix, $\alpha$ is a primitive element in GF(q), and $x$ is a certain element in a Galois field non-zero element set {1, 2, 3, ..., q-1}, which is determined at least by one of the described parameters, for example:

$$x = mod\left(h_{i,j}^b, q - 1\right) + 1$$, wherein the addition and subtraction operations are operations in a field of real numbers, and $h_{i,j}^b$, $q$, and 1 are all integers in the field of real numbers; or,

$$x = \alpha^{mod(h_{i,j}^b, q-1)}$$, wherein $\alpha$ is a primitive element in GF(q), the addition and subtraction operations are operations in the field of real numbers, and $h_{i,j}^b$, $q$, and 1 are all integers in the field of real numbers; or,

$x = mod(|i \pm j|, q-1) + 1$, wherein $i$ and $j$ respectively represent a row index and a column index of $h_{i,j}^b$ in the base matrix $Hb$, $| \cdot |$ represents an absolute value operation, the addition and subtraction operations are operations in the field of real numbers, and $i$, $j$, $q$, and 1 are all integers in the field of real numbers; or,

$x = \alpha^{mod(|i \pm j|, q-1)}$, wherein $\alpha$ is a primitive element in GF(q), $i$ and $j$ respectively represent a row index and a column index of $h_{i,j}^b$ in the base matrix $Hb$, $| \cdot |$ represents an absolute value operation, the addition and subtraction operations are operations in the field of real numbers, and $i$, $j$, $q$, and 1 are all integers in the field of real numbers; or,

$x = mod(|i \pm n_r|, q-1) + 1$, $i$ represents a row index of $h_{i,j}^b$ in the base matrix $Hb$, $n_r$ represents a column index in the extended matrix $H$ of the element "1" in the $r$-th row to be replaced in the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $i$, $n_r$, $q$, and 1 are all integers in the field of real numbers; or,

$x = \alpha^{mod(|i \pm n_r|, q-1)}$, $\alpha$ is a primitive element in GF(q), $i$ represents a row index of $h_{i,j}^b$ in the base matrix $Hb$, $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $i$, $n_r$, $q$, and 1 are all integers in the field of real numbers; or,

$x = mod(|j \pm m_r|, q-1) + 1$, wherein $j$ represents a column index of $h_{i,j}^b$ in the base matrix $Hb$, $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $j$, $m_r$, $q$, and 1 are all integers in the field of real numbers; or,

$x = \alpha^{mod(|j \pm m_r|, q-1)}$, wherein $\alpha$ is a primitive element in GF(q), $j$ represents a column index of $h_{i,j}^b$ in the base matrix $Hb$, $m_r$ represents a row index in the extended matrix $H$ of the element "1" to be replaced in the $r$-th row of in the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $j$, $m_r$, $q$, and 1 are all integers in the field of real numbers; or,

$x = mod(|m_r \pm n_r|, q - 1) + 1$, wherein $m_r$ and $n_r$ respectively represent a row index and a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $m_r$, $n_r$, $q$, and 1 are all integers in the field of real numbers; or,

$x = \alpha^{mod(|m_r \pm n_r|, q-1)}$, wherein $\alpha$ is a primitive element in GF(q), $m_r$ and $n_r$ respectively represent a row index and a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the addition and subtraction operations are operations in the field of real numbers, and $m_r$, $n_r$, $q$, and 1 are all integers in the field of real numbers; or,

$x = mod(m_r, q - 1) + 1$, wherein $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $m_r$, $q$, and 1 are all integers in the field of real numbers; or,

$x = \alpha^{mod(|m_r, q-1)}$, wherein $\alpha$ is a primitive element in GF(q), $m_r$ represents a row index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the subtraction operation is an operation in the field of real numbers, and $m_r$, $q$, and 1 are all integers in the field of real numbers; or,

$x = mod(n_r, q - 1) + 1$, wherein $n_r$ represents a column index in the extended matrix $H$ of the element "1" to be replaced in the $r$-th row of the cyclic shift matrix $P^{h_{i,j}^b}$ of the unit matrix (a selection rule of $r$ is agreed by a receiving end and a sending end of a communication system, for example, $r$ may be fixed as 0), the addition and subtraction operations are operations in the field of real numbers, and $n_r$, $q$, and 1 are all integers in the field of real numbers; or,

$x = \alpha^{mod(n_r, q-1)}$, wherein $\alpha$ is a primitive element in GF(q), $n_r$ represents a column index in the extended matrix H of the element "1" to be replaced in the r-th row of the cyclic shift matrix $P^{h_{i,j}^b}$ of the unit matrix (a selection rule of $r$ is agreed by a receiving end and a sending end of a communication system, for example, $r$ may be fixed as 0), $| \cdot |$ represents an absolute value operation, the subtraction operation is an operation in the field of real numbers, and $n_r$, $q$, and 1 are all integers in the field of real numbers.

(3) Replacing each non-zero element "1" in the extended matrix $H$ with a non-zero element in a Galois field value set, wherein the non-zero element is determined by at least one of the described parameters, for example:

$h_{m,n} = mod(|m \pm n|, q - 1) + 1$, wherein $m$ and $n$ respectively represent a row index and a column index in the extended matrix $H$ of the element "1" to be replaced by a non-zero element $h_{m,n}$, $| \cdot |$ represents an absolute value operation, the addition and subtraction operations are operations in the field of real numbers, and $m$, $n$, $q$, and 1 are all integers in the field of real numbers; or,

$h_{m,n} = \alpha^{mod(|m \pm n|, q-1)}$, $\alpha$ is a primitive element in GF(q), $m$ and $n$ respectively represent a row index and a column index in the extended matrix $H$ of the element "1" to be replaced by the non-zero element $h_{m,n}$, $| \cdot |$ represents an absolute value operation, the addition and subtraction operations are operations in the field of real numbers, and $m$, $n$, $q$ are all integers in the field of real numbers; or,

$h_{m,n} = mod(n, q - 1) + 1$, wherein $n$ represents a column index in the extended matrix $H$ of the element "1" to be replaced by the non-zero element $h_{m,n}$, the addition and subtraction operations are operations in the field of real numbers, and $n$, $q$, and 1 are all integers in the field of real numbers; or,

$h_{m,n} = \alpha^{mod(n,q-1)}$, wherein $\alpha$ is a primitive element in GF(q), $n$ represents a column index in the extended matrix $H$ of the element "1" to be replaced by the non-zero element $h_{m,n}$, the subtraction operation is an operation in the field of real numbers, and $n$, $q$, and 1 are all integers in the field of real numbers; or,

$h_{m,n} = mod(|n \pm i|, q - 1) + 1$, wherein $n$ represents a column index in the extended matrix $H$ of the element "1" to be replaced by the non-zero element $h_{m,n}$, $i$ represents a row index in the base matrix $Hb$ of the element $h_{i,j}^{b}$ indicating the cyclic shift value of the unit matrix corresponding to the cyclic shift matrix $P^{h_{i,j}^{b}}$ of the unit matrix having a dimension of $Z \times Z$ where the element "1" to be replaced by the non-zero element $h_{m,n}$ is located, $|\cdot|$ represents an absolute value operation, the addition and subtraction operations are operations in the field of real numbers, and $n$, $i$, $q$, and 1 are all integers in the field of real numbers; or,

$h_{m,n} = \alpha^{mod(|n \pm i|, q-1)}$, wherein $\alpha$ is a primitive element in GF(q), $n$ represents a column index in the extended matrix $H$ of the element "1" to be replaced by the non-zero element $h_{m,n}$, $i$ represents a row index in the base matrix $Hb$ of the element $h_{i,j}^{b}$ indicating the cyclic shift value of the unit matrix corresponding to the cyclic shift matrix $P^{h_{i,j}^{b}}$ of the unit matrix having a dimension of $Z \times Z$ where the element "1" to be replaced by the non-zero element $h_{m,n}$ is located, $|\cdot|$ represents an absolute value operation, the addition and subtraction operations are operations in the field of real numbers, and $n$, $i$, $q$, and 1 are all integers in the field of real numbers; or,

$h_{m,n} = mod(m, q - 1) + 1$, wherein m represents a row index in the extended matrix $H$ of the element "1" to be replaced by the non-zero element $h_{m,n}$, the addition and subtraction operations are operations in the field of real numbers, and m, $q$, and 1 are all integers in the field of real numbers; or,

$h_{m,n} = \alpha^{mod(m,q-1)}$, wherein $\alpha$ is a primitive element in GF(q), m represents a row index in the extended matrix $H$ of the element "1" to be replaced by the non-zero element $h_{m,n}$, the subtraction operation is an operation in the field of real numbers, and m, $q$, and 1 are all integers in the field of real numbers; or,

$h_{m,n} = mod(|m \pm j|, q - 1) + 1$, wherein m represents a row index in the extended matrix $H$ of the element "1" to be replaced by the non-zero element $h_{m,n}$, $j$ represents a column index in the base matrix $Hb$ of the element $h_{i,j}^{b}$ indicating the cyclic shift value of the unit matrix corresponding to the cyclic shift matrix $P^{h_{i,j}^{b}}$ of the unit matrix having a dimension of $Z \times Z$ where the element "1" to be replaced by the non-zero element $h_{m,n}$ is located, $|\cdot|$ represents an absolute value operation, the addition and subtraction operations are operations in the field of real numbers, and $m$, $j$, $q$, and I are all integers in the field of real numbers; or,

$h_{m,n} = \alpha^{mod(|m \pm j|, q-1)}$, wherein $\alpha$ is a primitive element in the GF(q), $m$ represents a row index in the extended matrix $H$ of the element "1" to be replaced by the non-zero element $h_{m,n}$, $j$ represents a column index in the base matrix $Hb$ of the element $h_{i,j}^{b}$ indicating the cyclic shift value of the unit matrix corresponding to the cyclic shift matrix $P^{h_{i,j}^{b}}$ of the unit matrix having a dimension of $Z \times Z$ where the element "1" to be replaced by the non-zero element $h_{m,n}$ is located, $|\cdot|$ represents an absolute value operation, the addition and subtraction operations are operations in the field of real numbers, and $m$, $j$, $q$, and 1 are all integers in the field of real numbers

**[0081]** Then, according to the parity check matrix $H_q$ of the non-binary quasi-cyclic LDPC code and a non-binary sequence to be coded, non-binary quasi-cyclic LDPC coding is performed. The process is specifically described as follows.

The bit sequence to be coded is converted into a non-binary sequence $u = [u_0, u_1, \ldots, u_{K-1}]$ to be coded, wherein $u_i \in \{0,1,2, \ldots, q - 1\}$, then the lifting factor $Z = K/Kb$. Let the coded codeword sequence be $c = [u, p] = [u_0, u_1, \ldots, u_{K-1}, p_0, p_1, \ldots, p_{M-1}]$, where M = Mb * Z, K + M = N = Nb $\times$ Z, then

$$H_q \cdot [\boldsymbol{u}, \boldsymbol{p}]^T = [H^u, H^p] \cdot [\boldsymbol{u}, \boldsymbol{p}]^T = 0,$$

that is, $H^p \boldsymbol{p}^T = H^u \boldsymbol{u}^T$, wherein $H^u$ and $H^p$ respectively represent a system block and a check block in the parity check matrix $Hq$, that is $Hq = [H^u, H^p]$, $H^u$ is composed by the first $K$ columns in the parity check matrix $Hq$ (the dimension of $H^u$ is M × K), and $H^p$ is composed of the last $M$ columns in the parity check matrix $Hq$ (the dimension of $H^p$ is M × M).

Based on the structural features of the base matrix of the parity check matrix $Hq$ of the non-binary quasi-cyclic LDPC code, the coding method described in the embodiment of the present disclosure may achieve coding based on $Hq$, where the first $M1 \times Z$ rows of the parity check matrix Hq are single-check rows, and the parity-check elements of the current row can be directly obtained from the current row vector of the parity check matrix Hq and the sequence to be coded. Further, each of the last $M2 \times Z$ rows of the parity check matrix Hq only has one unknown check bit and therefore the last $M2 \times Z$ rows are referred to as single-unknown-check rows, where the parity-check elements of the current row can be directly obtained from the current row vector of the parity check matrix Hq, the sequence to be coded, and the known parity-check elements of the first $M1 \times Z$ rows. Therefore, the coding method based on the parity check matrix Hq avoids matrix inversion operations over the Galois field, which can speed up the coding process and reduce complexity. The algorithm is as follows:

---

Algorithm: Coding method based on a non-binary parity check matrix $Hq$ as described in Scenario-based embodiment 2.

---

Input:
The non-binary parity check matrix Hq = [H$^u$, H$^p$]; a non-binary sequence $\mathbf{u}$ = [$u_0$, $u_1$, ... , $u_{K-1}$] to be coded.

---

Output:
A coded codeword sequence $\mathbf{c}$ = [$\mathbf{u}$, $\mathbf{p}$] = [$u_0$, $u_1$, ... , $u_{K-1}$, $p_0$, $p_1$, ... , $p_{M-1}$].

------ First, calculate the first M1*Z parity-check elements based on a first sub-matrix block-------

1: for $0 \leq i < M1$ do // Based on a single-check feature of the first sub-matrix block

2: j = i (main diagonal) or j = M1 - 1 - i (anti-diagonal)

3: for $0 \leq it < Z$ do

4: m = i * Z + it, $\quad n = j * Z + \mathrm{mod}(\mathrm{mod}(h_{i,j}^b, Z) + it, Z)$

5: $\quad p_n = H_m^u u^T / h_{m,n}^p$ , wherein $H_m^u$ , denotes a row vector of the m-th row of a system block matrix H$^u$; and

$h_{m,n}^p$ denotes an element in the m-th row and the n-th column of a check block matrix H$^p$;

------- Further, the last M2*Z parity-check elements is calculated based on a third sub-matrix block -------

6: for $M1 \leq i < Mb$ do // Based on a single-unknown-parity row feature of the third sub-matrix block

7: j = i (main diagonal) or j = Mb - 1 - (i - M1) (anti-diagonal)

8: for $0 \leq it < Z$ do

9: m = i * Z + it, $\quad n = j * Z + \mathrm{mod}(\mathrm{mod}(h_{i,j}^b, Z) + it, Z)$

10: $\quad p_n = (H_m^u \mathbf{u}^T + \sum_{k=0}^{M1*Z-1} h_{m,k}^p p_k) / h_{m,n}^p$

Note that the above arithmetic operations are all performed within the Galois field.

---

Scenario-based embodiment 3

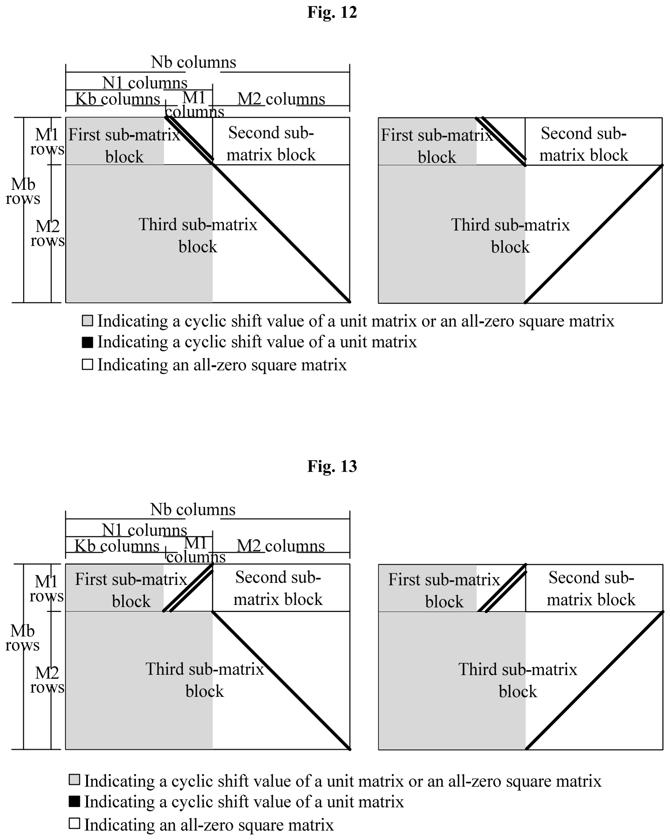

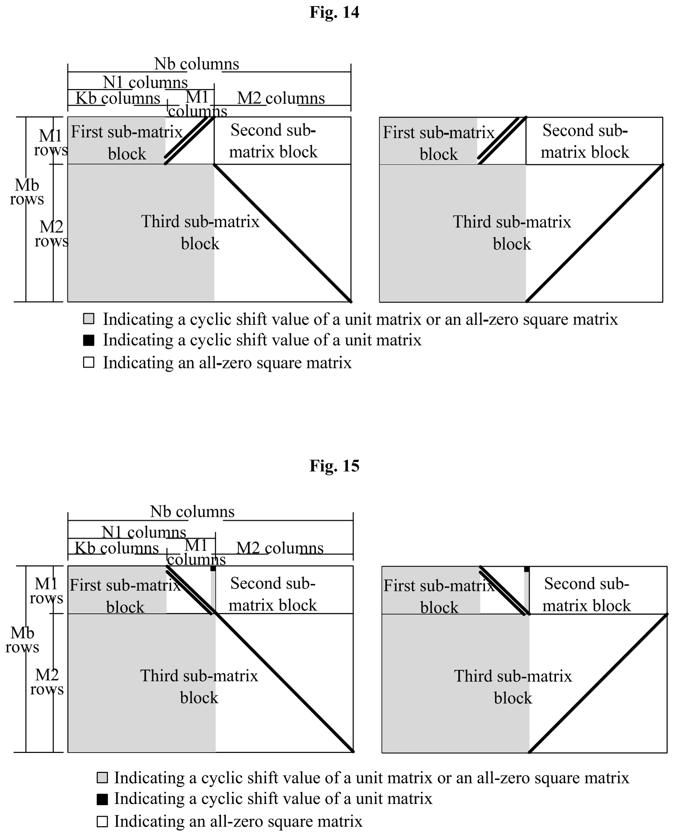

Scenario-based embodiment 3 differs from Scenario-based embodiment 2 in that: the check columns of the first sub-matrix, that is, the $M1 \times M1$ composed of the first $M1$ rows and the ($Kb$+1)-th to the $N1$-th columns of the base matrix $Hb$, have a double diagonal structure, or have a double diagonal structure after row exchange. The double diagonal structure of the first sub-matrix square of the base matrix may have different forms. Fig. 11 is a schematic diagram of an overall structure of a base matrix whose first sub-matrix square has a lower double main diagonal structure according to a scenario-based embodiment of the present disclosure. As shown in Fig. 11, all rows and the last $M1$ columns of the first sub-matrix of the base matrix have a lower double main diagonal structure. Fig. 12 is a schematic diagram of an overall structure of a base matrix whose first sub-matrix square has an upper double main diagonal structure according to a scenario-based embodiment of the present disclosure. As shown in Fig. 12, all rows and the last $M1$ columns of the first sub-matrix of the base matrix have an upper double main diagonal structure. Fig. 13 is a schematic diagram of an overall structure of a base matrix whose first sub-matrix square has a lower double anti-diagonal structure according to a scenario-based embodiment of the present disclosure. As shown in Fig. 13, all rows and the last $M1$ columns of the first sub-matrix of the base matrix have a lower double anti-diagonal structure. Fig. 14 is a schematic diagram of an overall structure of a base matrix whose first sub-matrix square has an upper double anti-diagonal structure according to a scenario-based embodiment of the present disclosure. As shown in Fig. 14, all rows and the last $M1$ columns of the first sub-matrix of the base matrix have an upper double anti-diagonal structure.

The base matrix is extended to obtain an extended matrix. In the current exemplary embodiment, the base matrix is extended based on a lifting factor $Z$ to obtain an extended matrix $H$. The extending process is the same as that in Scenario-based embodiment 2, and is not repeated herein.

According to the foregoing extended matrix, assuming that the set Galois field is GF(q), a replacement method for replacing the element "1" in the extended matrix $H$ with a certain non-zero element in a Galois field non-zero element set {1, 2, 3,..., q-1} to obtain the parity check matrix $Hq$ of the non-binary quasi-cyclic LDPC code is the same as that in Scenario-based embodiment 2, and is not further described herein.

Based on the structural features of the base matrix of the parity check matrix $Hq$ of the non-binary quasi-cyclic LDPC code, the coding method described in the embodiment of the present disclosure may achieve coding based on $Hq$, where the first row or the last row in the first sub-matrix block is always a single-check row, and the parity-check elements corresponding to the row after extension can be directly obtained from a row vector corresponding to the parity check matrix Hq and the sequence to be coded. Further, the remaining rows of the first sub-matrix block are sequentially single-unknown-check rows, and similarly, all the rows of the third sub-matrix square are single-unknown-check rows, and the single-unknown-check element of each row after extension can be directly calculated based on the current row vector of $Hq$, the known check elements, and the sequence to be coded. Therefore, the coding method based on the parity check matrix Hq avoids matrix inversion operations over the Galois field, which can speed up the coding process and reduce complexity. The algorithm is as follows:

---

Algorithm: Coding method based on a non-binary parity check matrix $Hq$ as described in Scenario-based embodiment 3.

---

Input:
The non-binary parity check matrix Hq = [$H^u$, $H^p$]; a non-binary sequence $\mathbf{u}$ = [$u_0$, $u_1$, ... , $u_{K-1}$] to be coded.

---

Output:
A coded codeword sequence $\mathbf{c}$ = [$\mathbf{u}$, $\mathbf{p}$] = [$u_0$, $u_1$, ..., $u_{K-1}$, $p_0$, $p_1$, ... , $p_{M-1}$].

---

\-\-\-\-\-\- First, calculate the first M1*Z parity-check elements based on a first sub-matrix block\-\-\-\-\-\-\-

\-\-\-\-\-\- Fig. 11 (Lower double main diagonal)

1:let (i,j) = (0,0)

2:for $0 \leq$ it < Z do

$$3: \quad m = i * Z + it, \ n = j * Z + \text{mod}\left(\text{mod}\left(h_{i,j}^b, Z\right) + it, Z\right), \ p_n = H_m^u \mathbf{u}^T / h_{m,n}^p$$

4:for 0 < $i$ < $M1$ do

5: j = i, (i',j') = (i,j - 1)

6: for $0 \leq$ it < Z do

$$7: \quad m = i * Z + it, \ n = j * Z + \text{mod}\left(\text{mod}\left(h_{i,j}^b, Z\right) + it, Z\right), n' = j' * Z +$$

$$\text{mod}\left(\text{mod}\left(h_{i',j'}^b, Z\right) + it, Z\right), p_n = (H_m^u \mathbf{u}^T + h_{m,n'}^p p_{n'}) / h_{m,n}^p$$

\-\-\-\- Fig. 12 (Upper double main diagonal)

1:let (i,j) = (M1 - 1, M1 - 1)

2:for $0 \leq$ it < Z do

3: Calculate m, n, $p_n = H_m^u \mathbf{u}^T / h_{m,n}^p$

4:while i > 0 do

$$5: \quad i = i - 1; \ j = i; \ (i', j') = (i, j + 1)$$

6: for $0 \leq$ it < Z do

(continued)

Output:

7: Calculate m, n, n', $p_n = (H_m^u \mathbf{u}^T + h_{m,n'}^p p_{n'})/h_{m,n}^p$

---- Fig. 13 (Lower double anti-diagonal)

1:let (i,j) = (0, M1 - 1)

2:for $0 \le it < Z$ do

3: Calculate m, n, $p_n = H_m^u \mathbf{u}^T / h_{m,n}^p$

4:for $0 < i < M1$ do

$$5: \quad j = M1 - 1 - i; \ (i', j') = (i, j + 1)$$

6: for $0 \le it < Z$ do

7: Calculate m, n, n', $p_n = (H_m^u \mathbf{u}^T + h_{m,n'}^p p_{n'})/h_{m,n}^p$

---- Fig. 14 (Upper double anti-diagonal)

1:let (i,j) = (M1 - 1,0)

2:for $0 \le it < Z$ do

3: Calculate m, n, $p_n = H_m^u \mathbf{u}^T / h_{m,n}^p$

4:while i > 0 do

$$5: \quad i = i - 1; \ j = M1 - 1 - i; \ (i', j') = (i, j - 1)$$

6: for $0 \le it < Z$ do

7: Calculate m, n, n', $p_n = (H_m^u \mathbf{u}^T + h_{m,n'}^p p_{n'})/h_{m,n}^p$

------ Then, the last M2*Z parity-check elements are calculated based on the third sub-matrix block -------
This embodiment is similar as Scenario-based embodiment 2, which is not further
described.
Note that the above arithmetic operations are all performed within the Galois field.

Scenario-based embodiment 4

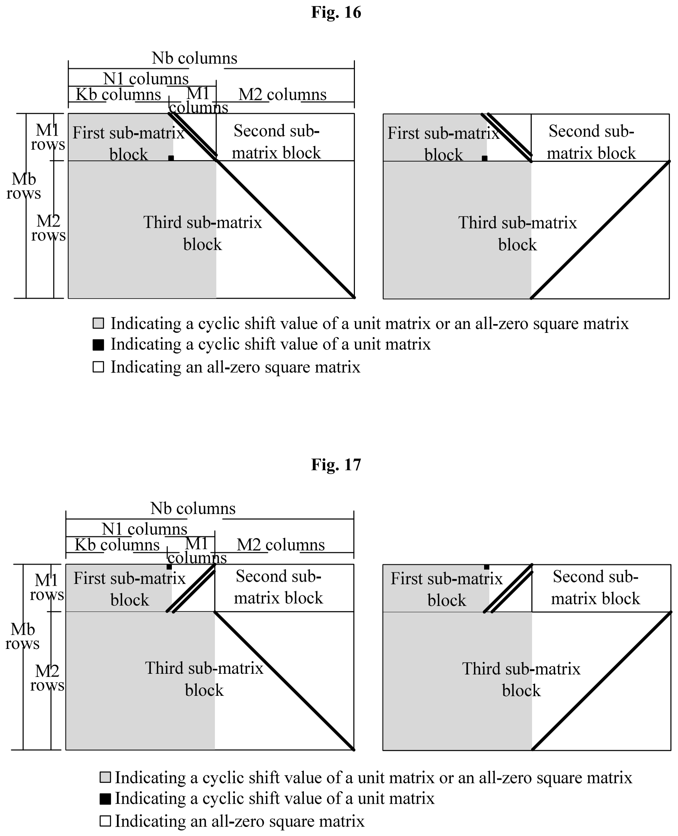

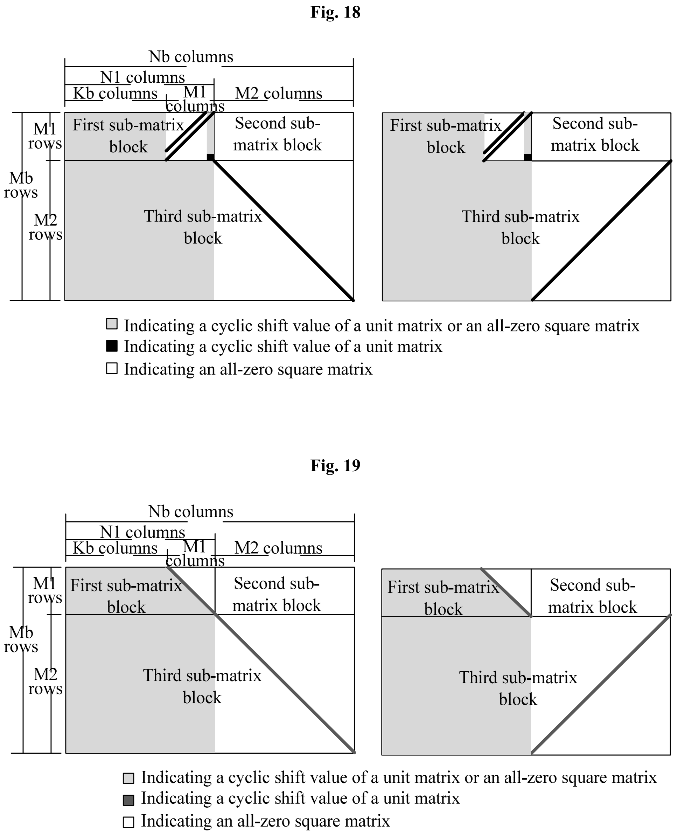

Scenario-based embodiment 4 differs from Scenario-based embodiment 2 in that: a $M1 \times M1$ square formed by all rows and the last *M*1 columns of the first sub-matrix has an approximate double diagonal structure, or has an approximate double diagonal structure after row exchange. The first sub-matrix square of the base matrix may have an approximate double diagonal structure in different forms. Fig. 15 is a schematic diagram of an overall structure of a base matrix whose first sub-matrix square has an approximate lower double main diagonal structure according to a scenario-based embodiment of the present disclosure. As shown in Fig. 15, all rows and the last *M*1 columns of the first sub-matrix of the base matrix have an approximate lower double main diagonal structure. Fig. 16 is a schematic diagram of an overall structure of a base matrix whose first sub-matrix square has an approximate upper double main diagonal structure according to a scenario-based embodiment of the present disclosure. As shown in Fig. 16, all rows and the last *M*1 columns of the first sub-matrix of the base matrix have an approximate upper double main diagonal structure. Fig. 17 is a schematic diagram of an overall structure of a base matrix whose first sub-matrix square has an approximate lower double anti-diagonal structure according to a scenario-based embodiment of the present disclosure. As shown in Fig. 17, all rows and the last *M*1 columns of the first sub-matrix of the base matrix have an approximate lower double anti-diagonal structure. Fig. 18 is a schematic diagram of an overall structure of a base matrix whose first sub-matrix square has an approximate upper double anti-diagonal structure according to a scenario-based embodiment of the present disclosure. As shown in Fig. 18, all rows and the last *M*1 columns of the first sub-matrix of the base matrix have an approximate upper double anti-diagonal structure.

The base matrix is extended to obtain an extended matrix. In the current exemplary embodiment, the base matrix is extended based on a lifting factor Z to obtain an extended matrix *H.* The extending process is the same as that in Scenario-based embodiment 2, and is not repeated herein.

According to the foregoing extended matrix, assuming that the set Galois field is GF(q), a replacement method for replacing the element "1" in the extended matrix $H$ with a certain non-zero element in a Galois field non-zero element set {1, 2, 3,..., q- 1} to obtain the parity check matrix $Hq$ of the non-binary quasi-cyclic LDPC code is the same as that in Scenario-based embodiment 2, and is not further described herein.

Based on the structural features of the base matrix of the parity check matrix $Hq$ of the non-binary quasi-cyclic LDPC code, the coding method described in the embodiment of the present disclosure may achieve coding based on $Hq$. This scenario-based embodiment is different from Scenario-based embodiment 2 in that the first row or the last row of the first sub-matrix block is not a single-check row. In this scenario-based embodiment, a matrix obtained by extending the check columns of the first sub-matrix block of the base matrix $Hb$ based on the lifting factor has full rank, a typical form thereof is as follows. In the column that reflects a structural feature difference from the double diagonal structure, only one element indicating the cyclic shift value of the unit matrix has a different cyclic shift value from the remaining elements indicating the cyclic shift value of the unit matrix in that column. In contrast, in the other columns, the elements indicating the cyclic shift value of the unit matrix within the same column share the same cyclic shift value, and the sub-matrixes of size $Z \times Z$ over the Galois field, obtained by extending those elements with the same cyclic shift value based on the lifting factor, are also identical. Based on this, in the present embodiment, the coding method based on $Hq$, as disclosed herein, is as follows. The coding method based on $Hq$ avoids matrix inversion operations over the Galois field, which can speed up the coding process and reduce complexity.

---

Algorithm: Coding method based on a non-binary parity check matrix $Hq$ as described in Scenario-based embodiment 4

---

Input:

the non-binary parity check matrix Hq = [H$^u$, H$^p$]; a non-binary sequence $\mathbf{u}$ = [$u_0$, $u_1$, ... , $u_{K-1}$] to be coded.

---

Output:

A coded codeword sequence $\mathbf{c}$ = [$\mathbf{u}$, $\mathbf{p}$] = [$u_0$, $u_1$, ... , $u_{K-1}$, $p_0$, $p_1$, ... , $p_{M-1}$].

------ First, calculate the first M1*Z parity-check elements based on a first sub-matrix block-------

------ Calculating parity-check elements corresponding to the column that reflects a structural feature difference from the double diagonal structure after extension 1:Finding a position index (xi, xj) of an element indicating a cyclic shift value of a unit matrix, whose cyclic shift value is different from other cyclic shift values in the column that reflects a structural feature difference from the double diagonal structure, for example, in Figs. 15 and 18, xj = M1 - 1; and in Figs. 16 and 17,

xj = 0

2:for 0 $\leq$ it < $Z$ do

3: sum_info = 0 Calculate xm, xn

4: for 0 $\leq$ i < M1 do

5: Calculating m, $\text{sum\_info} += H_m^u \mathbf{u}^T$

$$6: \quad p_{xn} = \text{sum\_info}/h_{xm,xn}^p$$

---------- Calculate parity-check elements corresponding to other columns

----- Fig. 15 (Approximate lower double main diagonal)

7:let i = M1

8:while i > 1 do

$$9: \quad i = i - 1, j = i - 1, (i', j') = (i, j + 1)$$

10: For 0 $\leq$ it < Z do

11: Calculate m, n, n', $p_n = (H_m^u \mathbf{u}^T + h_{m,n'}^p p_{n'})/h_{m,n}^p$

---- Fig. 16 (Approximate upper double main diagonal)

7:for 0 $\leq$ i < M1 - 1 do

$$8: \quad j = i + 1, (i', j') = (i, j - 1)$$

---

(continued)

Output:

9: For $0 \leq$ it $<$ Z do

10: Calculate m, n, n', $\quad p_n = (H_m^u \mathbf{u}^T + h_{m,n'}^p p_{n'})/h_{m,n}^p$

---- Fig. 17 (Approximate lower double anti-diagonal)

7:let i = M1

8:while i > 1 do

9: i = i - 1; j = M1 - 1 - i + 1; (i',j') = (i, j - 1)

10: for $0 \leq$ it $<$ Z do

11: Calculate m, n, n', $\quad p_n = (H_m^u \mathbf{u}^T + h_{m,n'}^p p_{n'})/h_{m,n}^p$

---- Fig. 18 (Approximate upper double anti-diagonal)

7:for $0 \leq$ i $<$ M1 - 1 do

$$8: \quad j = M1 - 1 - i - 1; \ (i', j') = (i, j + 1)$$

9: for $0 \leq$ it $<$ Z do

10: Calculate m, n, n', $\quad p_n = (H_m^u \mathbf{u}^T + h_{m,n'}^p p_{n'})/h_{m,n}^p$

------- Then, the last M2*Z check elements are calculated based on the third sub-matrix block----------

This embodiment is similar as Scenario-based embodiment 2, which is not further described.

Note that the above arithmetic operations are all performed within the Galois field.

Scenario-based embodiment 5

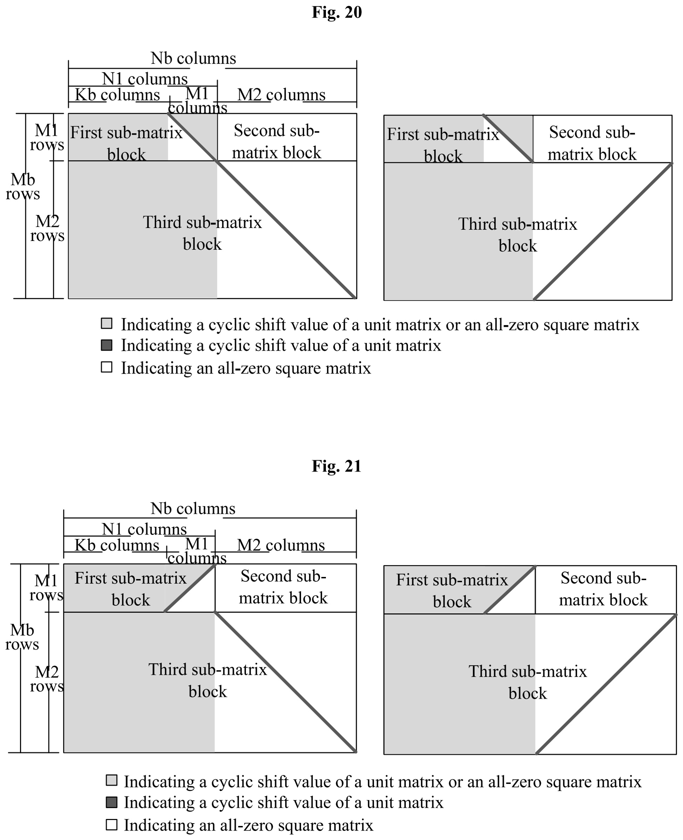

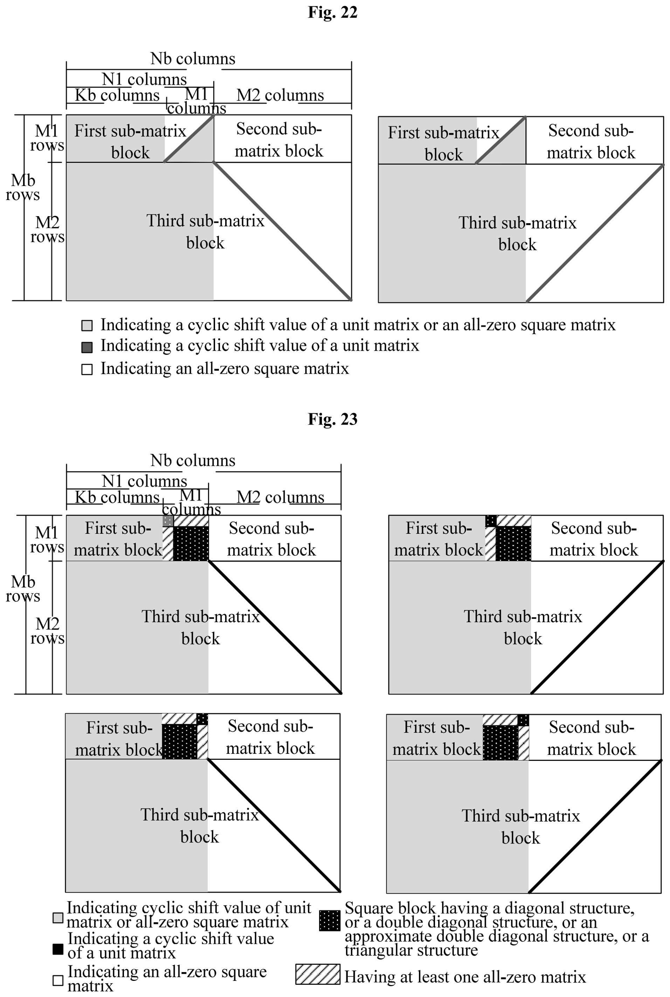

Scenario-based embodiment 5 differs from Scenario-based embodiment 2 in that: a $M1 \times M1$ square formed by all rows and the last $M1$ columns of the first sub-matrix has a triangular matrix structure, or has a triangular matrix structure after row exchange. The first sub-matrix square of the base matrix may have the triangular matrix structure in different forms. Fig. 19 is a schematic diagram of an overall structure of a base matrix whose first sub-matrix square has a lower main triangular matrix structure according to a scenario-based embodiment of the present disclosure. As shown in Fig. 19, all rows and the last $M1$ columns of the first sub-matrix have a lower main triangular matrix structure. Fig. 20 is a schematic diagram of an overall structure of a base matrix whose first sub-matrix square has an upper main triangular matrix structure according to a scenario-based embodiment of the present disclosure. As shown in Fig. 20, all rows and the last $M1$ columns of the first sub-matrix have an upper main triangular matrix structure. Fig. 21 is a schematic diagram of an overall structure of a base matrix whose first sub-matrix square has an upper anti-triangular matrix structure according to a scenario-based embodiment of the present disclosure. As shown in Fig. 21, all rows and the last $M1$ columns of the first sub-matrix have an upper anti-triangular matrix structure. Fig. 22 is a schematic diagram of an overall structure of a base matrix whose first sub-matrix square has a lower anti-triangular matrix structure according to a scenario-based embodiment of the present disclosure. As shown in Fig. 22, all rows and the last $M1$ columns of the first sub-matrix have a lower anti-triangular matrix structure.

The base matrix is extended to obtain an extended matrix. In the current exemplary embodiment, the base matrix is extended based on a lifting factor Z to obtain an extended matrix $H$. The extending process is the same as that in Scenario-based embodiment 2, and is not repeated herein.

According to the foregoing extended matrix, assuming that the set Galois field is GF(q), a replacement method for replacing the element "1" in the extended matrix $H$ with a certain non-zero element in a Galois field non-zero element set {1, 2, 3,..., q-1} to obtain the parity check matrix $Hq$ of the non-binary quasi-cyclic LDPC code is the same as that in Scenario-based embodiment 2, and is not further described herein.

Based on the structural features of the base matrix of the parity check matrix $Hq$ of the non-binary quasi-cyclic LDPC code, the coding method described in the embodiment of the present disclosure may achieve coding based on $Hq$, where the first row or the last row in the first sub-matrix block is always a single-check row, and the parity-check elements corresponding to the row after extension can be directly obtained from a row vector corresponding to the parity check matrix Hq and the sequence to be coded. Further, the remaining rows of the first sub-matrix block are sequentially single-unknown-check rows, and similarly, all the rows of the third sub-matrix square are single-unknown-check rows, and the single-unknown-check element of each row after extension can be directly calculated based on the current row vector of *Hq,* the known check elements, and the sequence to be coded. Therefore, the coding method based on the parity check matrix Hq avoids matrix inversion operations over the Galois field, which can speed up the coding process and reduce complexity. The algorithm is as follows:

---

Algorithm: Coding method based on a non-binary parity check matrix *Hq* as described in Scenario-based embodiment 5

---

Input:

---

A non-binary parity check matrix Hq = [$H^u$, $H^p$]; a non-binary sequence $\mathbf{u}$ = [$u_0$, $u_1$, ... , $u_{K-1}$] to be coded.
Output:
A coded codeword sequence $\mathbf{c}$ = [$\mathbf{u}$, $\mathbf{p}$] = [$u_0$, $u_1$, ..., $u_{K-1}$, $p_0$, $p_1$, ... , $p_{M-1}$].

------ First, calculate the first M1*Z parity-check elements based on a first sub-matrix block ------
----- Fig. 19 (Lower main triangular matrix)
1:let (i, j) = (0,0)
2:for $0 \leq it < Z$ do

3: Calculate m, n,  $p_n = H_m^u \mathbf{u}^T / h_{m,n}^p$

4:For $0 < i < M1$ do

$$5: \quad j = i, \ i' = i,$$

6: For $0 \leq it < Z$ do

7: Calculate m, n,  $p_n = (H_m^u \mathbf{u}^T + \sum_{j'=0}^{j-1} h_{m,n'}^p p_{n'}) / h_{m,n}^p$

---- Fig. 20 (Upper main triangular matrix)
1:let (i, j) = (M1 - 1, M1 - 1)
2: for $0 \leq it < Z$ do

3: Calculate m, n,  $p_n = H_m^u u^T / h_{m,n}^p$

4:while i > 0 do

$$5: \quad i = i - 1; \ j = i; \ i' = i$$

6: for $0 \leq it < Z$ do

7: Calculate m, n,  $p_n = (H_m^u \mathbf{u}^T + \sum_{j'=j+1}^{M1-1} h_{m,n'}^p p_{n'}) / h_{m,n}^p$

---- Fig. 21 (Upper anti-triangular matrix)
1:let (i, j) = (M1 - 1,0)
2:for $0 \leq it < Z$ do

3: Calculate m, n,  $p_n = H_m^u \mathbf{u}^T / h_{m,n}^p$

4:while i > 0 do

$$5: \quad i = i - 1; \ j = M1 - 1 - i; \ i' = i$$

6: for $0 \leq it < Z$ do

7: Calculate m, n,  $p_n = (H_m^u \mathbf{u}^T + \sum_{j'=0}^{j-1} h_{m,n'}^p p_{n'}) / h_{m,n}^p$

---- Fig. 22 (Lower anti-triangular matrix)
1:let (i, j) = (0, M1 - 1)
2:for $0 \leq it < Z$ do

3: Calculate m, n,  $p_n = H_m^u \mathbf{u}^T / h_{m,n}^p$

(continued)

| 4:For 0 < *i* < M1 do |
| --- |

$$5: \quad j = M1 - 1 - i; \; i' = i$$

6: for $0 \le it < Z$ do

7: Calculate m, n, $\quad p_n = (H_m^u \mathbf{u}^T + \sum_{j'=j+1}^{M1-1} h_{m,n'}^p p_{n'}) / h_{m,n}^p$

------Then, the last M2*Z parity-check elements are calculated based on the third sub-matrix block -------
This embodiment is similar as Scenario-based embodiment 2, which is not further described.

Note that the above arithmetic operations are all performed within the Galois field.

Scenario-based embodiment 6

Scenario-based embodiment 6 differs from Scenario-based embodiment 2 in that: Fig. 23 is a schematic diagram of an overall structure of a base matrix whose first sub-matrix square has a combined structure according to a scenario-based embodiment of the present disclosure, as shown in Fig. 23, the check columns of the first sub-matrix, that is, the M1 * M1 square formed by the front *M*1 rows and the (Kb + 1)-th to the N1-th columns in the base matrix *Hb,* have a combined structure.

The base matrix is extended to obtain an extended matrix. In the current exemplary embodiment, the base matrix is extended based on a lifting factor Z to obtain an extended matrix *H*. The extending process is the same as that in Scenario-based embodiment 2, and is not repeated herein.

According to the foregoing extended matrix, assuming that the set Galois field is GF(q), a replacement method for replacing the element "1" in the extended matrix *H* with a certain non-zero element in a Galois field non-zero element set {1, 2, 3,..., q-1} to obtain the parity check matrix *Hq* of the non-binary quasi-cyclic LDPC code is the same as that in Scenario-based embodiment 2, and is not further described herein.

Based on the structural features of the base matrix of the parity check matrix *Hq* of the non-binary quasi-cyclic LDPC code, the coding method described in the embodiment of the present disclosure may achieve coding based on *Hq.* The M1 × M1 square matrix formed by the check columns in the first sub-matrix block is divided into four sub-matrix blocks, wherein the sub-matrices in the same row as the all-zero sub-matrices have a diagonal structure, or a double diagonal structure, or an approximate double diagonal structure, or a triangular structure, and therefore corresponding parity-check elements may be calculated by using a coding method similar to those in Scenario-based embodiments 2 to 5. In addition, parity-check elements at the remaining positions in the *M*1 × *M*1 square matrix exist in another sub-matrix square, and according to a diagonal structure, or a double diagonal structure, or an approximate double diagonal structure, or a triangular structure of the sub-matrix square, the corresponding parity-check elements can also be calculated by correspondingly using a coding method similar to those in Scenario-based embodiments 2 to 5. In addition, the algorithm for solving the unknown check elements in the third sub-matrix square is the same as that in Scenario-based embodiment 2, and is not further described.

Scenario-based embodiment 7

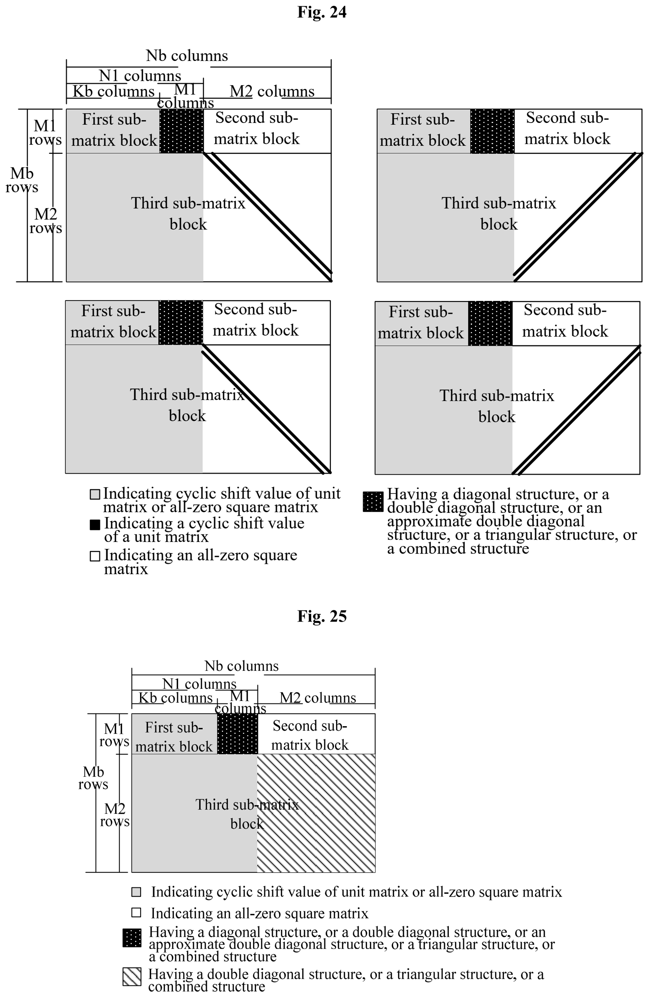

Fig. 24 is an overall structural diagram of a base matrix according to a scenario-based embodiment of the present disclosure. As shown in Fig. 24, in a first sub-matrix composed of the first *M*1 rows and the first *N*1 columns of the base matrix *Hb* of the non-binary quasi-cyclic LDPC code, check columns of the first sub-matrix, that is, the front *M*1 rows and the (*Kb*+1)-th to the N1-th columns of the base matrix *Hb,* have a diagonal structure, or a double diagonal structure, or an approximate double diagonal structure, or a triangular matrix structure, or a combined structure, or has a diagonal structure, or a double diagonal structure, or an approximate double diagonal structure, or a triangular matrix structure, or a combined structure after row exchange. A second sub-matrix formed by the first *M*1 rows and the last *Nb-N1* rows of the base matrix of the non-binary quasi-cyclic LDPC code is an all-zero matrix. The (*M*1+1)-th to the *M*b-th rows (i.e., the last *Mb-M*1 rows) and all columns of the base matrix of the non-binary quasi-cyclic LDPC code form a third sub-matrix, and the third sub-matrix is used for supporting non-binary quasi-cyclic LDPC coding with a low bit rate. The third sub-matrix has a dimension of *M2* × *Nb,* wherein *M2* = *Mb - M*1, all rows and the last *M2* columns of the third sub-matrix have a double diagonal structure, or have a double diagonal structure after row exchange.

The base matrix is extended to obtain an extended matrix. In the current exemplary embodiment, the base matrix is extended based on a lifting factor Z to obtain an extended matrix *H*. The extending process is the same as that in Scenario-based embodiment 2, and is not repeated herein.

According to the foregoing extended matrix, assuming that the set Galois field is GF(q), a replacement method for replacing the element "1" in the extended matrix *H* with a certain non-zero element in a Galois field non-zero element set {1, 2, 3,..., q-1} to obtain the parity check matrix *Hq* of the non-binary quasi-cyclic LDPC code is the same as that in Scenario-based embodiment 2, and is not further described herein.

Based on the structural features of the base matrix of the parity check matrix *Hq* of the non-binary quasi-cyclic LDPC code, the coding method described in the embodiment of the present disclosure may achieve coding based on *Hq*. The $M1 \times M1$ square matrix formed by the check columns in the first sub-matrix block has a diagonal structure, or a double diagonal structure, or an approximate double diagonal structure, or a triangular structure, or a combined structure, and corresponding parity-check elements may be calculated by using a coding method similar to those in Scenario-based embodiments 2 to 6. In addition, the unknown check columns in the third sub-matrix block have a double diagonal structure, and the corresponding parity-check elements can be obtained by using the coding method similar to that in Scenario-based embodiment 3, which will not be repeated here.

Scenario-based embodiment 8

Fig. 25 is an overall structural diagram of a base matrix according to a scenario-based embodiment of the present disclosure. As shown in Fig. 25, Scenario-based embodiment 8 differs from Scenario-based embodiment 7 in that: all rows and the last *M2* columns of the third sub-matrix have an approximate double diagonal structure, or a triangular matrix structure, or a combined structure, or has an approximate double diagonal structure, or a triangular matrix structure, or a combined structure after row exchange.

The base matrix is extended to obtain an extended matrix. In the current exemplary embodiment, the base matrix is extended based on a lifting factor Z to obtain an extended matrix *H*. The extending process is the same as that in Scenario-based embodiment 2, and is not repeated herein.

According to the foregoing extended matrix, assuming that the set Galois field is GF(q), a replacement method for replacing the element "1" in the extended matrix *H* with a certain non-zero element in a Galois field non-zero element set {1, 2, 3,..., q-1} to obtain the parity check matrix *Hq* of the non-binary quasi-cyclic LDPC code is the same as that in Scenario-based embodiment 2, and is not further described herein.

Based on the structural features of the base matrix of the parity check matrix *Hq* of the non-binary quasi-cyclic LDPC code, the coding method described in the embodiment of the present disclosure may achieve coding based on *Hq*. The $M1 \times M1$ square matrix formed by the check columns in the first sub-matrix block has a diagonal structure, or a double diagonal structure, or an approximate double diagonal structure, or a triangular structure, or a combined structure, and corresponding parity-check elements may be calculated by using a coding method similar to those in Scenario-based embodiments 2 to 6. Furthermore, the unknown check columns in the third sub-matrix square have an approximate double diagonal structure, or a triangular matrix structure, or a combined structure, and the corresponding parity-check elements can be obtained by using a coding method similar to those in Scenario-based embodiments 4 to 6, which is not described herein again.

In conclusion, according to the above embodiments, a coding method for a non-binary quasi-cyclic LDPC code is provided, including the following operations: determining a base matrix *Hb*; determining an extended matrix *H* according to the base matrix and a lifting factor; determining non-binary values at non-zero positions in the extended matrix *H* to obtain a parity check matrix *Hq* of a non-binary quasi-cyclic LDPC code; performing non-binary LDPC coding on an input information bit sequence according to the parity check matrix *Hq* to obtain a codeword sequence to be sent. The technical solutions provided in the embodiments of the present disclosure can support an efficient and fast coding algorithm, and reduce storage space and coding complexity.

The above are only exemplary embodiments of the present disclosure, and are not intended to limit the embodiments of the present disclosure. For those having ordinary skill in the art, the embodiments of the present disclosure may have various modifications and variations. Any modifications, equivalent replacements, improvements and the like made within the principle of the embodiments of the present disclosure shall fall within the scope of protection of the embodiments of the present disclosure.

**Claims**

1. A coding method for a non-binary quasi-cyclic Low Density Parity Check, LDPC, code, comprising:

   determining a base matrix of a non-binary quasi-cyclic LDPC code, wherein the base matrix comprises a first element indicating an all-zero square matrix and a second element indicating a cyclic shift value of a unit matrix;
   extending the base matrix according to a lifting factor to obtain an extended matrix;
   obtaining a parity check matrix of the non-binary quasi-cyclic LDPC code according to non-binary values at non-zero positions in the extended matrix; and
performing non-binary quasi-cyclic LDPC coding on an input information bit sequence based on the parity check matrix to obtain a codeword sequence to be sent.

2. The coding method according to claim 1, wherein
the base matrix has a dimension of $Mb \times Nb$, and the first $M1$ rows and the first $N1$ columns of the base matrix form a first sub-matrix, wherein $Mb$, $Nb$, $M1$, and $N1$ are integers greater than 0, $M1 < Mb$, and $N1 < Nb$.

3. The coding method according to claim 2, wherein
the first $M1$ rows and the $(Kb+1)$-th to the $N1$-th columns of the base matrix form a first sub-matrix square, wherein $Kb$ is the number of system columns, $Kb = N1 - M1$, and a structural feature of the first sub-matrix square or the first sub-matrix square after row exchange comprises at least one of: a diagonal structure, a double diagonal structure, an approximate double diagonal structure, a triangular matrix structure, or a combined structure.

4. The coding method according to claim 2, wherein
the first $M1$ rows and the last $Nb - N1$ columns of the base matrix form a second sub-matrix, and the second sub-matrix is an all-zero matrix.

5. The coding method according to claim 2, wherein
the $(M1 + 1)$-th to the $Mb$-th rows of the base matrix and all columns of the base matrix form a third sub-matrix used for supporting non-binary quasi-cyclic LDPC coding with a low code rate.

6. The coding method according to claim 5, wherein

the third sub-matrix has a dimension of $M2 \times Nb$, all rows and the last $M2$ columns of the third sub-matrix form a third sub-matrix square, and a structural feature of the third sub-matrix square or the third sub-matrix square after row exchange comprises at least one of: a diagonal structure, a double diagonal structure, an approximate double diagonal structure, a triangular matrix structure, or a combined structure,
wherein $M2 = Mb - M1$.

7. The coding method according to claim 1, wherein extending the base matrix according to the lifting factor to obtain the extended matrix comprises:
extending the first element in the base matrix into an all-zero square matrix having a dimension of $Z \times Z$, and extending

the second element in the base matrix into a cyclic shift matrix $P^{h_{i,j}^b}$ of the unit matrix having a dimension of $Z \times Z$, so as to obtain the extended matrix, wherein the base matrix has a dimension of $Mb \times Nb$, the extended matrix has a

dimension of $(Mb \times Z) \times (Nb \times Z)$, $Z$ is the lifting factor, $Mb$, $Nb$ and $Z$ are all positive integers, $h_{i,j}^b$ is the second element, i is a row index of the second element in the base matrix, and j is a column index of the second element in the base matrix.

8. The coding method according to claim 1, wherein obtaining the parity check matrix of the non-binary quasi-cyclic LDPC code according to the non-binary values at the non-zero positions in the extended matrix comprises:
determining the non-binary values at the non-zero positions in the extended matrix, and replacing elements at the non-zero positions in the extended matrix with corresponding non-zero elements in a non-binary Galois field value set to obtain the parity check matrix.

9. The coding method according to claim 8, wherein the elements at the non-zero positions in the extended matrix are replaced with the corresponding non-zero elements in the non-binary Galois field value set according to a determination parameter, wherein the determination parameter comprises at least one of:

a size of the non-binary Galois field value set;
a primitive element of the non-binary Galois field value set;
the second element;
the lifting factor of the base matrix;
a row index of the second element in the base matrix;
a column index of the second element in the base matrix;
a row index of the non-zero positions in the extended matrix; or

a column index of the non-zero positions in the extended matrix.

10. The coding method according to claim 7 or 9, wherein obtaining the parity check matrix of the non-binary quasi-cyclic LDPC code according to the non-binary values at the non-zero positions in the extended matrix comprises:

replacing a cyclic shift matrix $P^{h^b_{i,j}}$ of the unit matrix having a dimension of $Z \times Z$ in the extended matrix with $xP^{h^b_{i,j}}$, wherein $x$ is a non-zero element of a non-binary Galois field value set.

11. The coding method according to claim 7 or 9, wherein obtaining the parity check matrix of the non-binary quasi-cyclic LDPC code according to the non-binary values at the non-zero positions in the extended matrix comprises:

replacing a cyclic shift matrix $P^{h^b_{i,j}}$ of the unit matrix having a dimension of $Z \times Z$ in the extended matrix with $P^{h^b_{i,j}}Z(x)$ to obtain the parity check matrix, wherein $Z(x) = \text{diag}\{x, \alpha x, \alpha^2 x, ..., \alpha^{Z-1}x\}$, diag {} denotes a diagonal matrix, $\alpha$ is a primitive element of a non-binary Galois field value set, and $x$ is a non-zero element of the non-binary Galois field value set.

12. A coding device for a non-binary quasi-cyclic Low Density Parity Check, LDPC, code, comprising:

a determination module, configured to determine a base matrix of a non-binary quasi-cyclic LDPC code, wherein the base matrix comprises a first element indicating an all-zero square matrix and a second element indicating a cyclic shift value of a unit matrix;
an extension module, configured to extend the base matrix according to a lifting factor to obtain an extended matrix;
an obtaining module, configured to obtain a parity check matrix of the non-binary quasi-cyclic LDPC code according to non-binary values at non-zero positions in the extended matrix; and
a coding module, configured to perform non-binary quasi-cyclic LDPC coding on an input information bit sequence based on the parity check matrix to obtain a codeword sequence to be sent.

13. A computer-readable storage medium, wherein the computer-readable storage medium stores a computer program, and the computer program, when executed by a processor, causes the processor to execute the coding method according to any one of claims 1 to 11.

14. An electronic device, comprising a memory, a processor, and a computer program stored in the memory and executable on the processor, wherein the processor, when executing the computer program, implements the coding method according to any one of claims 1 to 11.

**Fig. 1**

**Fig. 2**

**Fig. 3**

| Determining a base matrix of a non-binary quasi-cyclic LDPC code, wherein the base matrix comprises a first element for indicating an all-zero square matrix and a second element for indicating a cyclic shift value of a unit matrix | S302 |

↓

| Extending the base matrix according to a lifting factor to obtain an extended matrix | S304 |

↓

| Obtaining a parity check matrix of the non-binary quasi-cyclic LDPC code according to non-binary values at non-zero positions in the extended matrix | S306 |

↓

| Performing non-binary quasi-cyclic LDPC coding on an input information bit sequence based on the parity check matrix to obtain a codeword sequence to be sent | S308 |

**Fig. 4**

Coding device 40

Determination module 410

Extension module 420

Obtaining module 430

Coding module 440

**Fig. 5**

M1 columns

M1 rows

Main diagonal structure

M1 columns

M1 rows

Anti-diagonal structure

Element indicating a cyclic shift value of a unit matrix

Element indicating an all-zero square matrix

**Fig. 6**

Lower double main diagonal structure

Upper double main diagonal structure

Lower double anti-diagonal structure

Upper double anti-diagonal structure

▨ Element indicating a cyclic shift value of a unit matrix

☐ Element indicating an all-zero square matrix

**Fig. 7**

Approximate lower double
main diagonal structure

Approximate upper double
main diagonal structure

Approximate lower double
anti-diagonal structure

Approximate upper double
anti-diagonal structure

Element indicating a cyclic shift value of a unit matrix

Element indicating an all-zero square matrix

Element indicating a cyclic shift value of a unit matrix
or element indicating an all-zero square matrix

Column reflecting a structural feature different from a
double diagonal structure

**Fig. 8**

M1 columns

M1 rows

Upper main triangular matrix structure

M1 columns

M1 rows

Lower main triangular matrix structure

M1 columns

M1 rows

Upper anti-triangular matrix structure

M1 columns

M1 rows

Lower anti-triangular matrix structure

Element indicating a cyclic shift value of a unit matrix

Element indicating an all-zero square matrix

Element indicating a cyclic shift value of a unit matrix or element indicating an all-zero square matrix

**Fig. 9**

| M11 columns | M1-M11 columns |
| --- | --- |
| M11 rows | Square matrix 1 | Rectangular matrix 1 |
| M1-M11 rows | Rectangular matrix 2 | Square matrix 2 |

| M1-M11 columns | M11 columns |
| --- | --- |
| M11 rows | Rectangular matrix 1 | Square matrix 1 |
| M1-M11 rows | Square matrix 2 | Rectangular matrix 2 |

**Fig. 10**

☐ Indicating a cyclic shift value of a unit matrix or an all-zero square matrix
■ Indicating a cyclic shift value of a unit matrix
☐ Indicating an all-zero square matrix

**Fig. 11**

☐ Indicating a cyclic shift value of a unit matrix or an all-zero square matrix
■ Indicating a cyclic shift value of a unit matrix
☐ Indicating an all-zero square matrix

**Fig. 12**

☐ Indicating a cyclic shift value of a unit matrix or an all-zero square matrix
■ Indicating a cyclic shift value of a unit matrix
☐ Indicating an all-zero square matrix

**Fig. 13**

☐ Indicating a cyclic shift value of a unit matrix or an all-zero square matrix
■ Indicating a cyclic shift value of a unit matrix
☐ Indicating an all-zero square matrix

**Fig. 14**

Nb columns

N1 columns

Kb columns | M1 columns | M2 columns

M1 rows

Mb rows

M2 rows

First sub-matrix block

Second sub-matrix block

Third sub-matrix block

First sub-matrix block

Second sub-matrix block

Third sub-matrix block

☐ Indicating a cyclic shift value of a unit matrix or an all-zero square matrix
■ Indicating a cyclic shift value of a unit matrix
☐ Indicating an all-zero square matrix

**Fig. 15**

Nb columns

N1 columns

Kb columns | M1 columns | M2 columns

M1 rows

Mb rows

M2 rows

First sub-matrix block

Second sub-matrix block

Third sub-matrix block

First sub-matrix block

Second sub-matrix block

Third sub-matrix block

☐ Indicating a cyclic shift value of a unit matrix or an all-zero square matrix
■ Indicating a cyclic shift value of a unit matrix
☐ Indicating an all-zero square matrix

**Fig. 16**

☐ Indicating a cyclic shift value of a unit matrix or an all-zero square matrix
■ Indicating a cyclic shift value of a unit matrix
☐ Indicating an all-zero square matrix

**Fig. 17**

☐ Indicating a cyclic shift value of a unit matrix or an all-zero square matrix
■ Indicating a cyclic shift value of a unit matrix
☐ Indicating an all-zero square matrix

**Fig. 18**

□ Indicating a cyclic shift value of a unit matrix or an all-zero square matrix
■ Indicating a cyclic shift value of a unit matrix
□ Indicating an all-zero square matrix

**Fig. 19**

□ Indicating a cyclic shift value of a unit matrix or an all-zero square matrix
■ Indicating a cyclic shift value of a unit matrix
□ Indicating an all-zero square matrix

**Fig. 20**

☐ Indicating a cyclic shift value of a unit matrix or an all-zero square matrix
■ Indicating a cyclic shift value of a unit matrix
☐ Indicating an all-zero square matrix

**Fig. 21**

☐ Indicating a cyclic shift value of a unit matrix or an all-zero square matrix
■ Indicating a cyclic shift value of a unit matrix
☐ Indicating an all-zero square matrix

**Fig. 22**

☐ Indicating a cyclic shift value of a unit matrix or an all-zero square matrix
■ Indicating a cyclic shift value of a unit matrix
☐ Indicating an all-zero square matrix

**Fig. 23**

☐ Indicating cyclic shift value of unit matrix or all-zero square matrix
■ Indicating a cyclic shift value of a unit matrix
☐ Indicating an all-zero square matrix

▦ Square block having a diagonal structure, or a double diagonal structure, or an approximate double diagonal structure, or a triangular structure

▨ Having at least one all-zero matrix

**Fig. 24**

☐ Indicating cyclic shift value of unit matrix or all-zero square matrix

■ Indicating a cyclic shift value of a unit matrix

☐ Indicating an all-zero square matrix

▨ Having a diagonal structure, or a double diagonal structure, or an approximate double diagonal structure, or a triangular structure, or a combined structure

**Fig. 25**

☐ Indicating cyclic shift value of unit matrix or all-zero square matrix

☐ Indicating an all-zero square matrix

■ Having a diagonal structure, or a double diagonal structure, or an approximate double diagonal structure, or a triangular structure, or a combined structure

▨ Having a double diagonal structure, or a triangular structure, or a combined structure

## INTERNATIONAL SEARCH REPORT

| International application No. |
|---|
| **PCT/CN2023/137968** |

**A. CLASSIFICATION OF SUBJECT MATTER**

H03M13/11(2006.01)i

According to International Patent Classification (IPC) or to both national classification and IPC

**B. FIELDS SEARCHED**

Minimum documentation searched (classification system followed by classification symbols)

IPC:H03M

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: LDPC, 非二进制, 编码, 基础矩阵, 校验矩阵, 提升因子, 扩展因子, none binary, basic matrix, check matrix, extension factor

**C. DOCUMENTS CONSIDERED TO BE RELEVANT**

| Category* | Citation of document, with indication, where appropriate, of the relevant passages | Relevant to claim No. |
|---|---|---|
| X | CN 107888198 A (ZTE CORP.) 06 April 2018 (2018-04-06) description, paragraphs 4-165 | 1, 7, 12-14 |
| Y | CN 107888198 A (ZTE CORP.) 06 April 2018 (2018-04-06) description, paragraphs 4-165 | 2-6, 13-14 |
| Y | CN 109150197 A (HUAWEI TECHNOLOGIES CO., LTD.) 04 January 2019 (2019-01-04) description, paragraphs 65-78, and figure 2 | 2-6, 13-14 |
| A | CN 115865102 A (CHINA AGRICULTURAL UNIVERSITY) 28 March 2023 (2023-03-28) entire document | 1-14 |
| A | WO 2009060627 A1 (PANASONIC CORP.) 14 May 2009 (2009-05-14) entire document | 1-14 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 March 2024** | **14 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

EP 4 693 906 A1

**INTERNATIONAL SEARCH REPORT**
Information on patent family members

International application No.

**PCT/CN2023/137968**

| Patent document cited in search report | | | Publication date (day/month/year) | Patent family member(s) | | | Publication date (day/month/year) |
|---|---|---|---|---|---|---|---|
| CN | 107888198 | A | 06 April 2018 | US | 2022085830 | A1 | 17 March 2022 |
| | | | | US | 11637568 | B2 | 25 April 2023 |
| | | | | US | 2023344450 | A1 | 26 October 2023 |
| | | | | US | 2020028523 | A1 | 23 January 2020 |
| | | | | US | 11133826 | B2 | 28 September 2021 |
| | | | | WO | 2018059588 | A1 | 05 April 2018 |
| | | | | EP | 3522379 | A1 | 07 August 2019 |
| | | | | EP | 3522379 | A4 | 11 September 2019 |
| | | | | CN | 107888198 | B | 26 May 2023 |
| | | | | CN | 116683917 | A | 01 September 2023 |
| CN | 109150197 | A | 04 January 2019 | MY | 196344 | A | 24 March 2023 |
| | | | | BR | 112019027876 | A2 | 07 July 2020 |
| | | | | US | 2022231705 | A1 | 21 July 2022 |
| | | | | US | 11671116 | B2 | 06 June 2023 |
| | | | | JP | 2022179504 | A | 02 December 2022 |
| | | | | PL | 3567731 | T3 | 28 February 2022 |
| | | | | EP | 3567731 | A1 | 13 November 2019 |
| | | | | EP | 3567731 | A4 | 01 July 2020 |
| | | | | EP | 3567731 | B1 | 12 January 2022 |
| | | | | US | 2020052720 | A1 | 13 February 2020 |
| | | | | US | 10771092 | B2 | 08 September 2020 |
| | | | | KR | 20200013794 | A | 07 February 2020 |
| | | | | KR | 102276721 | B1 | 12 July 2021 |
| | | | | ES | 2907089 | T3 | 21 April 2022 |
| | | | | JP | 2020526111 | A | 27 August 2020 |
| | | | | JP | 7143343 | B2 | 28 September 2022 |
| | | | | AU | 2018294981 | A1 | 30 January 2020 |
| | | | | AU | 2018294981 | B2 | 22 October 2020 |
| | | | | RU | 2020102671 | A | 27 July 2021 |
| | | | | RU | 2020102671 | A3 | 07 September 2021 |
| | | | | RU | 2758968 | C2 | 03 November 2021 |
| | | | | BR | 112019027688 | A8 | 29 September 2020 |
| | | | | US | 2021058095 | A1 | 25 February 2021 |
| | | | | US | 11277153 | B2 | 15 March 2022 |
| | | | | CA | 3068553 | A1 | 03 January 2019 |
| | | | | US | 2023361787 | A1 | 09 November 2023 |
| | | | | EP | 4064573 | A1 | 28 September 2022 |
| | | | | EP | 4064573 | B1 | 27 December 2023 |
| CN | 115865102 | A | 28 March 2023 | None | | | |
| WO | 2009060627 | A1 | 14 May 2009 | JPWO | 2009060627 | A1 | 17 March 2011 |
| | | | | US | 2010251062 | A1 | 30 September 2010 |
| | | | | CN | 101431337 | A | 13 May 2009 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310481751